(19) Europäisches Patentamt
European Patent Office
Office européen des brevets

(11) **EP 4 768 456 A1**

(12) **EUROPEAN PATENT APPLICATION**
published in accordance with Art. 153(4) EPC

(43) Date of publication:
**01.07.2026 Bulletin 2026/27**

(21) Application number: **24909685.0**

(22) Date of filing: **19.07.2024**

(51) International Patent Classification (IPC):
*C03C 17/22* (2006.01)    *C03C 17/34* (2006.01)
*G02B 1/14* (2015.01)    *G02B 1/11* (2015.01)
*H05K 5/03* (2006.01)

(52) Cooperative Patent Classification (CPC):
C03C 17/22; C03C 17/34; C03C 17/36;
C23C 14/06; C23C 14/08; C23C 14/10;
C23C 14/24; C23C 14/35; G02B 1/11; G02B 1/14;
H04M 1/18; H05K 5/03

(86) International application number:
**PCT/CN2024/106527**

(87) International publication number:
**WO 2025/138731 (03.07.2025 Gazette 2025/27)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **26.12.2023 CN 202311819284**

(71) Applicant: **Honor Device Co., Ltd.
Shenzhen 518040 (CN)**

(72) Inventors:
• **MIAO, Dengkui
Shenzhen, Guangdong 518040 (CN)**

• **XU, Wenbin
Shenzhen, Guangdong 518040 (CN)**
• **WANG, Wei
Shenzhen, Guangdong 518040 (CN)**
• **HAN, Shuai
Shenzhen, Guangdong 518040 (CN)**
• **CHEN, Qiuqun
Shenzhen, Guangdong 518040 (CN)**

(74) Representative: **Gill Jennings & Every LLP
The Broadgate Tower
20 Primrose Street
London EC2A 2ES (GB)**

(54) **COVER PLATE AND ELECTRONIC DEVICE**

(57)    This application provides a cover plate and an electronic device, and relates to the field of electronic product technologies, to improve scratch resistance of the cover plate and ensure an appearance yield of the cover plate. This can take into account both the scratch resistance and the appearance yield of the cover plate. The cover plate includes a substrate and a scratch-resistant film layer that are disposed in a stacked manner. The scratch-resistant film layer includes a silicon element and a doped element, a valence state of the doped element is a valence of +3 or a valence of +5, and the doped element does not include a nitrogen element.

FIG. 7

## Description

This application claims priority to Chinese Patent Application No. 202311819284.2, filed with the China National Intellectual Property Administration on December 26, 2023 and entitled "COVER PLATE AND ELECTRONIC DEVICE", which is incorporated herein by reference in its entirety.

## TECHNICAL FIELD

This application relates to the field of electronic product technologies, and in particular, to a cover plate and an electronic device.

## BACKGROUND

When an electronic device, for example, a mobile phone or a tablet computer, is used without being adhered to a protective film, a cover plate, for example, a light-transmitting cover plate or a back cover, generally has a scratch visible to the naked eye after the electronic device is used for approximately one month. In addition, as use time of the electronic device is prolonged, there are more scratches on the cover plate. Stress balance of the cover plate may be damaged due to existence of these scratches, and consequently, impact resistance of the cover plate is reduced. At the same time, these scratches, or even a scratch that is not quite obvious, hinders visual effect and reduces a reputation of the electronic device.

In a cover plate in a related technology, a scratch-resistant film layer is usually disposed to improve scratch resistance of the cover plate, to reduce a scratch on the cover plate. However, the cover plate in the related technology cannot take into account both the scratch resistance and an appearance yield of the cover plate.

## SUMMARY

This application provides a cover plate and an electronic device, to improve scratch resistance of the cover plate and ensure an appearance yield of the cover plate. This can take into account both the scratch resistance and the appearance yield of the cover plate.

To achieve the foregoing objectives, the following technical solutions are used in embodiments of this application.

According to a first aspect, this application provides a cover plate. The cover plate includes a substrate and a scratch-resistant film layer that are disposed in a stacked manner. The scratch-resistant film layer includes a silicon element and a doped element, a valence state of the doped element is a valence of +3 or a valence of +5, and the doped element does not include a nitrogen element.

In the cover plate in this application, the scratch-resistant film layer including the doped element is disposed, so that in a process of sputtering the scratch-resistant film layer, electric charge accumulation on a surface of a silicon target can be effectively avoided. This helps to reduce a probability of generating an arc discharge phenomenon in the process of sputtering, and can further avoid generation of a large-particle sputtering substance in the process of sputtering, thereby effectively reducing a probability of forming a "white spot" on a surface of the substrate, and improving an appearance yield of the cover plate.

In a possible implementation of the first aspect, the doped element includes at least one of a boron element, a phosphorus element, and an aluminum element. These elements can form covalent bonds with the silicon element, and can effectively reduce the probability of forming a "white spot" on the surface of the substrate in the process of sputtering the scratch-resistant film layer. In addition, these elements have low costs and are easily obtained.

In a possible implementation of the first aspect, a mass fraction of the doped element in the scratch-resistant film layer is greater than or equal to 0.2%. In this way, an electrical conductivity of the silicon target can be effectively improved.

In a possible implementation of the first aspect, the mass fraction of the doped element in the scratch-resistant film layer is less than or equal to 3%. In this way, impact of the doped element on optical performance of the cover plate can be avoided.

In a possible implementation of the first aspect, Vickers hardness of the scratch-resistant film layer is greater than or equal to 1100 HV. In this way, wear resistance, corrosion resistance, drop resistance, scratch resistance, and the like of the cover plate can be improved, thereby helping to reduce a scratch on the cover plate. This can improve aesthetic appearance of the cover plate and an electronic device including the cover plate, and prolong service lives of the cover plate and the electronic device.

In a possible implementation of the first aspect, the scratch-resistant film layer includes a first material and a second material, a refractive index of the first material is greater than or equal to a refractive index of the substrate, and a refractive index of the second material is less than or equal to the refractive index of the substrate. In this way, after the first material and the second material are mixed, a refractive index of the scratch-resistant film layer can be adjusted, and a difference between the refractive index of the scratch-resistant film layer and the refractive index of the substrate can be reduced, thereby reducing difficulty in adjusting optical performance and an appearance color of the cover plate. This helps to thin a thickness of an optical adjustment film layer, can further reduce a difference between optical thicknesses of the optical adjustment film layer at different incident angles, and can effectively improve an angle discoloration problem and a rainbow edge problem. Therefore, the optical adjustment film layer is not only applicable to a 2D cover plate, but also applicable to a 3D cover plate or a 2.5D cover plate.

In a possible implementation of the first aspect, the substrate is a glass substrate, and the refractive index of the scratch-resistant film layer is greater than or equal to 1.46 and less than or equal to 1.85. A refractive index $n_g$ of the glass substrate is approximately 1.52. By setting the refractive index $n_k$ of the scratch-resistant film layer to be greater than or equal to 1.46 and less than or equal to 1.85, this can reduce the difference between the refractive index of the scratch-resistant film layer and the refractive index of the substrate, so that a material of the scratch-resistant film layer is approximately homogeneous with a material of the substrate, which can reduce difficulty in adjusting the optical performance and the appearance color of the cover plate. This helps to thin the thickness of the optical adjustment film layer, to effectively improve both the angle discoloration problem and the rainbow edge problem.

In a possible implementation of the first aspect, the refractive index of the scratch-resistant film layer is greater than or equal to 1.65 and less than or equal to 1.85. In this way, when both the angle discoloration problem and the rainbow edge problem are improved, it is ensured that the scratch-resistant film layer has high Vickers hardness.

In a possible implementation of the first aspect, the first material includes at least one of silicon nitride, aluminum nitride, niobium oxide, titanium oxide, and tantalum oxide. Optical performance of these materials are good, and can satisfy a requirement for the refractive index of the first material. In addition, Vickers hardness of these materials is high, and can increase hardness of the optical adjustment film layer, thereby further improving the scratch resistance of the cover plate.

In a possible implementation of the first aspect, the second material includes at least one of silicon oxide, magnesium fluoride, and calcium fluoride. Optical performance of these materials is good, and can satisfy a requirement for the refractive index of the second material.

In a possible implementation of the first aspect, the first material includes at least one of silicon nitride, aluminum nitride, niobium oxide, titanium oxide, and tantalum oxide; and the second material includes at least one of silicon oxide, magnesium fluoride, and calcium fluoride.

In a possible implementation of the first aspect, the first material is silicon nitride, the second material is silicon oxide, and a mass fraction of the first material is greater than or equal to 10% and or less than or equal to 80%. In this way, the refractive index of the scratch-resistant film layer may be controlled to 1.49 to 1.85. This can reduce the difference between the refractive index of the scratch-resistant film layer and the refractive index of the substrate, and effectively improve the angle discoloration problem and the rainbow edge problem of the cover plate.

In a possible implementation of the first aspect, the first material is silicon nitride, the second material is silicon oxide, and a mass fraction of the first material is greater than or equal to 10% and less than or equal to 50%. In this way, the refractive index of the scratch-resistant film layer may be controlled to 1.49 to 1.66. This can further reduce the difference between the refractive index of the scratch-resistant film layer and the refractive index of the substrate.

In a possible implementation of the first aspect, the first material is aluminum oxide, the second material is silicon oxide, and a mass fraction of the first material is greater than or equal to 10% and less than 100%. In this way, the refractive index of the scratch-resistant film layer may be controlled to 1.47 to 1.7. This can reduce the difference between the refractive index of the scratch-resistant film layer and the refractive index of the substrate, and effectively improve the angle discoloration problem and the rainbow edge problem of the cover plate.

In a possible implementation of the first aspect, the first material is aluminum oxide, the second material is silicon oxide, and a mass fraction of the first material is greater than or equal to 20% and less than 80%. In this way, the refractive index of the scratch-resistant film layer may be controlled to 1.49 to 1.62. This can further reduce the difference between the refractive index of the scratch-resistant film layer and the refractive index of the substrate.

In a possible implementation of the first aspect, a thickness of the scratch-resistant film layer is greater than or equal to 500 nm. In this way, a scratch resistance function of the scratch-resistant film layer can be ensured.

In a possible implementation of the first aspect, the thickness of the scratch-resistant film layer is less than or equal to 3000 nm. In this way, the scratch resistance function of the scratch-resistant film layer can be ensured, the scratch resistance of the cover plate can be improved, and an overall thickness of the cover plate can be reduced.

In a possible implementation of the first aspect, the cover plate includes an upper optical adjustment film layer. The upper optical adjustment film layer is disposed on a side that is of the scratch-resistant film layer and that faces away from the substrate, the upper optical adjustment film layer is a single layer, and a refractive index of the upper optical adjustment film layer is less than the refractive index of the scratch-resistant film layer. In this way, by designing the upper optical adjustment film layer as a single-layer film system, a structure of the upper optical adjustment film layer can be simplified, and a total thickness of the optical adjustment film layer can be reduced, thereby reducing a difference between optical thicknesses of the optical adjustment film layer at different incident angles, and improving the angle discoloration problem and the rainbow edge problem. In addition, the scratch-resistant film layer and the upper optical adjustment film layer may form a composite film layer with a high-refractive-index film layer and a low-refractive-index film layer that are superimposed. Light rays reflected and refracted by the scratch-resistant film layer and the upper optical adjustment film layer interfere with each other, so that reflectivity of light in a specific wave band in an emergent light ray can be enhanced, and a light-transmitting rate of the cover plate can be further improved, to optimize the optical performance of the cover plate and adjust the appearance color of the cover plate.

In a possible implementation of the first aspect, the upper optical adjustment film layer includes at least one high-refractive-index material and at least one low-refractive-index material, and a refractive index of the high-refractive-index material is greater than a refractive index of the low-refractive-index material. In this way, by adjusting a mass ratio of the high-refractive-index material to the low-refractive-index material, the upper optical adjustment film layer has a corresponding refractive index, which can reduce difficulty in processing the upper optical adjustment film layer.

In a possible implementation of the first aspect, the cover plate includes the upper optical adjustment film layer. The upper optical adjustment film layer is disposed on the side that is of the scratch-resistant film layer and that faces away from the substrate, the upper optical adjustment film layer includes at least one first high-refractive-index film layer and at least one first low-refractive-index film layer that are sequentially stacked and alternately disposed, and a refractive index of the first high-refractive-index film layer is greater than a refractive index of the first low-refractive-index film layer. Another structure of the upper optical adjustment film layer is provided.

In a possible implementation of the first aspect, a physical thickness of the upper optical adjustment film layer is less than or equal to 300 nm In this way, a difference between optical thicknesses of the upper optical adjustment film layer at different incident angles can be reduced, thereby improving the angle discoloration problem and the rainbow edge problem of the cover plate.

In a possible implementation of the first aspect, a ratio of a physical thickness of the scratch-resistant film layer to the physical thickness of the upper optical adjustment film layer is greater than or equal to 10. In this way, there is a large difference between the thicknesses of the scratch-resistant film layer and the upper optical adjustment film layer, so that the scratch-resistant film layer and the upper optical adjustment film layer may be considered as a single-layer film system as a whole, thereby further improving the angle discoloration problem and the rainbow edge problem of the cover plate.

In a possible implementation of the first aspect, the refractive index of the upper optical adjustment film layer is greater than or equal to 1.55 and less than or equal to 1.65. In this way, this helps to reduce the difference between optical thicknesses of the upper optical adjustment film layer at different incident angles, thereby improving the angle discoloration problem and the rainbow edge problem of the cover plate.

In a possible implementation of the first aspect, the cover plate includes a lower optical adjustment film layer. The lower optical adjustment film layer is disposed on a side that is of the scratch-resistant film layer and that faces the substrate. For example, the lower optical adjustment film layer may be disposed on a surface of the side that is of the scratch-resistant film layer and that faces the substrate. In this way, the optical performance of the cover plate can be further improved.

In a possible implementation of the first aspect, the lower optical adjustment film layer is a single-layer film layer, and a refractive index of the lower optical adjustment film layer is less than a refractive index of a scratch-resistant upper film layer. A specific structure of the lower optical adjustment film layer is provided.

In a possible implementation of the first aspect, the refractive index of the lower optical adjustment film layer is greater than or equal to 1.55 and less than or equal to 1.65. In this way, this helps to reduce a difference between optical thicknesses of the lower optical adjustment film layer at different incident angles, thereby improving the angle discoloration problem and the rainbow edge problem of the cover plate. In addition, these materials are easily obtained, and can reduce difficulty in processing the cover plate.

In a possible implementation of the first aspect, the cover plate includes a hard slip layer. The hard slip layer is disposed on the side that is of the scratch-resistant film layer and that faces away from the substrate. The hard slip layer may be used for reducing a dynamic friction coefficient of a surface of the cover plate, and reducing a shear force on the surface of the cover plate when the surface of the cover plate is rubbed. In this way, damage to film layers of the cover plate when a user touches the cover plate can be avoided. In addition, the user can have a smooth touch when touching the cover plate, which helps to improve user experience.

In a possible implementation of the first aspect, the hard slip layer includes one or more carbon materials containing $SP_2$ bonds. These materials have high hardness, can satisfy a requirement of the hard slip layer for the dynamic friction coefficient, and can further improve the wear resistance, the scratch resistance, and the like of the cover plate while reducing a friction force on the surface of the cover plate.

In a possible implementation of the first aspect, the dynamic friction coefficient of the hard slip layer is less than or equal to 0.05. In this way, damage to the film layers of the cover plate when the user touches the cover plate can be avoided. In addition, the user can have a smooth touch when touching the cover plate, which helps to improve user experience.

In a possible implementation of the first aspect, the dynamic friction coefficient of the hard slip layer may be greater than or equal to 0.01. In this way, a material of the hard slip layer can be easily obtained, and difficulty in processing the hard slip layer can be reduced.

In a possible implementation of the first aspect, a physical thickness of the hard slip layer is less than or equal to 50 nm. In this way, the optical performance of the cover plate can be ensured while reducing the friction force on the surface of the cover plate.

In a possible implementation of the first aspect, the cover plate further includes an anti-fingerprint layer. The anti-fingerprint layer is disposed on the side that is of the scratch-resistant film layer and that faces away from the substrate. In this way, an appearance surface of the cover plate has anti-fingerprint performance.

In a possible implementation of the first aspect, a material of the anti-fingerprint layer includes at least one of polytetrafluoroethylene and cloflucarban. These materials have lyophobic and oleophobic properties, so that the surface of the cover plate is easy to clean, and has excellent fingerprint resistance.

In a possible implementation of the first aspect, the cover plate includes: a primer layer. The primer layer is disposed in a stacked manner on a surface that is of the substrate and that faces the scratch-resistant film layer. A material of the primer layer includes at least one of aluminum, chromium, titanium, silicon, and silicon oxide. The primer layer is used for increasing an adhesion force between the substrate and a film layer of a first surface that is closest to the substrate, and can effectively prevent a film layer on the substrate from falling off. In addition, the primer layer can further provide an etch-stop interface for removing a bad product film layer, to prevent a removal solution from damaging the substrate.

In a possible implementation of the first aspect, according to the International Commission on Illumination, under an incident condition that an incident angle is equal to 60°, a value a and a value b of a reflection color of the cover plate in the Lab color space satisfy: the value a is greater than or equal to -2 and less than or equal to 2, and the value b is greater than or equal to -2 and less than or equal to 2. In this way, the appearance color of the cover plate is good, and coating can be performed on a 2.5D cover plate 50 and a 3D cover plate. In addition, even if an arc surface of an edge part of the cover plate reaches 90°, there is no angle discoloration problem and rainbow edge problem.

In a possible implementation of the first aspect, Mohs hardness of the cover plate under a force of 500 g is greater than 7. In this way, the cover plate has high hardness, and has good wear resistance and scratch resistance. This helps to reduce a scratch on the cover plate and prolong a service life of the cover plate.

In a possible implementation of the first aspect, the substrate is a 2.5D substrate or a 3D substrate

According to a second aspect, this application provides an electronic device, including a frame, a screen, and a back cover. The screen includes a light-transmitting cover plate and a display that are disposed in a stacked manner, the light-transmitting cover plate is fixedly connected to the frame, the back cover is disposed on a side that is of the frame and that faces away from the light-transmitting cover plate, and at least one of the back cover and the light-transmitting cover plate is the cover plate in any one of the foregoing technical solutions.

For technical effects brought by any design manners in the second aspect, refer to the technical effects brought by different design manners in the first aspect. Details are not described herein again.

## BRIEF DESCRIPTION OF DRAWINGS

FIG. 1 is a diagram of a structure of an electronic device according to some embodiments of this application;
FIG. 2 is a cross-sectional view of the electronic device in FIG. 1 along a line A-A;
FIG. 3 is a side view of different shapes of cover plates;
FIG. 4 is a diagram of a cross-sectional structure of a cover plate in a related technology;
FIG. 5 is a diagram of changes of spectra of the cover plate shown in FIG. 4 at different incident angles;
FIG. 6 is a diagram of a cross-sectional structure of another cover plate in a related technology;
FIG. 7 is a partial cross-sectional view of a cover plate according to some embodiments of this application;
FIG. 8 is a partial cross-sectional view of a cover plate according to some other embodiments of this application;
FIG. 9 is a partial cross-sectional view of a cover plate according to some other embodiments of this application;
FIG. 10 is a partial cross-sectional view of a cover plate according to still other embodiments of this application;
FIG. 11 is a partial cross-sectional view of a cover plate according to still other embodiments of this application;
FIG. 12 is a flowchart of a processing method for a cover plate according to some embodiments of this application;
FIG. 13 is a flowchart of a processing method for a cover plate according to some other embodiments of this application;
FIG. 14 is a flowchart of a processing method for a cover plate according to still other embodiments of this application;
FIG. 15 is a flowchart of a processing method for the cover plate shown in FIG. 10; and
FIG. 16 is a flowchart of a processing method for the cover plate shown in FIG. 11.

REFERENCE NUMERALS:

100: electronic device; 10: screen 10; 11: light-transmitting cover plate; 12: display; 20: housing; 21: back cover; 22: frame; 23: middle plate; 30: circuit board; 31: main circuit board; 32: auxiliary circuit board; 40: battery; 50: cover plate; 501: middle part; 502: edge part; 50a: dimple; 51: substrate; 511: first surface; 512: second surface; 52: coating film layer; 521: optical adjustment film layer; 5211: upper optical adjustment film layer; 5211a: first high-refractive-index film layer; 5211b: second low-refractive-index film layer; 5212: lower optical adjustment film layer; 5212a: second high-refractive-index film layer; 5212b: second low-refractive-index film layer; 522: scratch-resistant film layer; 523: primer layer; 524: anti-fingerprint layer; 525: transition layer; 526: hard slip layer; 53: diamond-like carbon film layer.

## DESCRIPTION OF EMBODIMENTS

The following describes the technical solutions in embodiments of this application with reference to the accompanying drawings in embodiments of this application. It is clear that the described embodiments are merely a part rather than all of embodiments of this application.

In embodiments of this application, terms such as "example" or "for example" are used to represent giving an example, an illustration, or a description. Any embodiment or design scheme described as "example" or "for example" in embodiments of this application should not be explained as being more preferred or having more advantages than another embodiment or design scheme. Exactly, use of the term "example", "for example", or the like is intended to present a related concept in a specific manner.

In embodiments of this application, terms "first" and "second" are used merely for a purpose of description, and shall not be understood as an indication or implication of relative importance or implicit indication of a quantity of indicated technical features. Therefore, a feature limited by "first" or "second" may explicitly or implicitly include one or more of such features.

In embodiments of this application, "and/or" is merely an association relationship describing related objects, and means that three relationships may exist. For example, A and/or B may represent the following three cases: Only A exists, both A and B exist, and only B exists. In addition, a character "/" in this specification generally indicates an "or" relationship between the associated objects.

In embodiments of this application, direction terms such as "inside", "outside", "upper", and "lower" are defined relative to a direction in which a component is schematically placed in the accompanying drawings. It should be understood that these direction terms are relative concepts that are used for descriptive and clarity purposes, and may vary correspondingly depending on the direction in which the component is placed in the accompanying drawings.

In the description of embodiments of this application, it should be noted that unless otherwise specified and defined explicitly, terms "mount", "connect", and "connection" should be understood in a broad sense. For example, "connection" may be a detachable connection or a non-detachable connection; or may be a direct connection or an indirect connection through an intermediate medium. "Fixedly connected" means connected to each other with an unchanged relative positional relationship after the connection.

In descriptions of embodiments of this application, terms "directionally consistent", "perpendicular", "parallel", and "equal" include a stated case and a case similar to the stated case. A range of the similar case falls within an acceptable deviation range, and the acceptable deviation range is determined by a person of ordinary skill in the art while considering measurement in question and an error (that is, a limitation of a measurement system) related to measurement of a particular quantity. For example, "parallel" includes absolutely parallel and approximately parallel, and an acceptable deviation range of the approximately parallel may be, for example, a deviation within 5°, 8°, or 10°. "Perpendicular" includes absolutely perpendicular and approximately perpendicular, and an acceptable deviation range of the approximately perpendicular may be, for example, a deviation within 5°, 8°, or 10°. "Equal" includes absolutely equal and approximately equal, and an acceptable deviation range of the approximately equal may be, for example, that a difference between two equal objects is less than or equal to 5%, 8%, or 10% of either of the two objects.

For ease of understanding, before a cover plate and an electronic device in embodiments of this application are introduced in detail, related terms in embodiments of this application are described first.

Physical thickness of a film layer: is an actual thickness of the film layer, and may also be referred to as a "geometric thickness".

Optical thickness of the film layer: is a product of a refractive index of the film layer and the physical thickness of the film layer.

Physical vapor deposition (physical vapor deposition, PVD): The physical vapor deposition is a technology in which a surface of a material source (a solid or a liquid) is gasified by using a physical method under a vacuum condition to form a gas-state atomic or particle, or is partially ionized to form an ion, and a thin film having a special function is deposited on a substrate surface in a gas phase process. The physical vapor deposition technology includes a vacuum evaporation technology and a magnetron sputtering technology.

Sputtering (sputtering): is one of PVD thin film production technologies, and is mainly classified into four types: direct current sputtering, alternating current sputtering, reactive sputtering, and magnetron sputtering. A principle of the sputtering is: a process in which when a target is bombarded by a charged particle and a solid surface is bombarded by an accelerated ion, a surface atomic collision and energy and momentum transfers occur, so that a target atom escapes from the surface and deposits on a substrate material.

(L*, a*, b*) colorimetric system: may also be referred to as Lab color space (also referred to as CIELab color space), and is one of representation methods of a color. The Lab color space is a color mode that is determined by the International Commission on Illumination (or referred to as the CIE organization) and theoretically includes all colors that can be seen by human eyes. The (L*, a*, b*) colorimetric system includes three elements: a value L, a value a, and a value b. The value L represents brightness, a value range is [0, 100], and represents from pure black to pure white; the value a represents a range from red to green, and a value range is [127, -128]; and the value b represents a range from yellow to blue, and a value range is [127, -128]. All colors are formed by interaction changes of the three values.

The value L, the value a, and the value b in the (L*, a*, b*) colorimetric system may be measured by using a colorimeter, for example, may be measured by using a CM3600 colorimeter.

Covalent bond: A strong interaction formed between several adjacent atoms through sharing electrons and between the shared electrons is referred to as a covalent bond. The essence of the covalent bond is that after atomic trajectories overlap, an electrical interaction between an electron between two nuclei and the two nuclei occurs with a high probability.

Embodiments of this application provide an electronic device. The electronic device includes a cover plate, and the cover plate can be used as a light-transmitting cover plate, a back cover, and the like of the electronic device. In the electronic device in embodiments of this application, a scratch-resistant film layer is disposed on a substrate of the cover plate, and a doped element that can form a covalent bond with a silicon element is disposed in the scratch-resistant film layer, so that an appearance defect rate generated in a film coating process can be reduced. Therefore, scratch resistance of the cover plate can be improved, and aesthetic appearance of the electronic device can be improved.

Embodiments of this application provide an electronic device. The electronic device includes, but is not limited to, a mobile phone, a tablet computer, a notebook computer, a laptop computer (laptop computer), a personal digital assistant (personal digital assistant, PDA), a personal computer, an in-vehicle device, a wearable device, a walkman, a radio, a television, a speaker box, and the like. The wearable device includes, but is not limited to, a band, a watch, a smart head-mounted display, smart clothing, smart glasses, headphones, and the like.

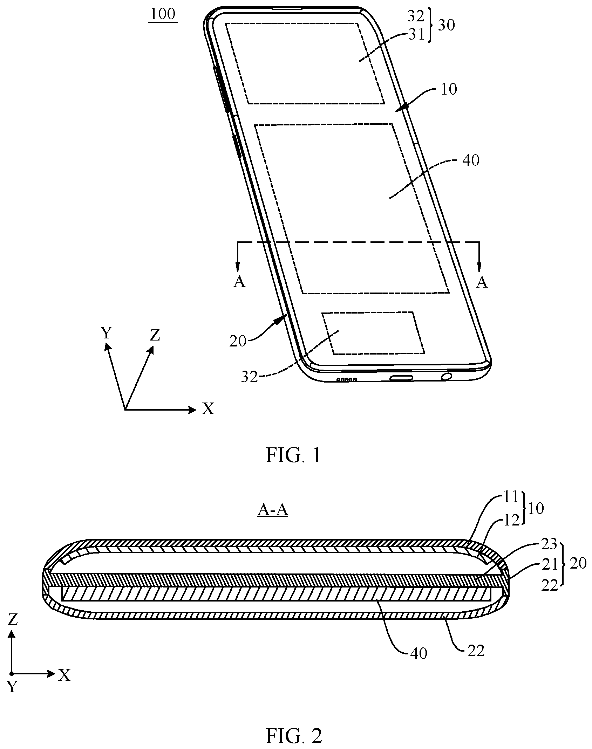

Refer to FIG. 1 and FIG. 2. FIG. 1 is a diagram of a structure of an electronic device 100 according to some embodiments of this application. FIG. 2 is a cross-sectional view of the electronic device 100 in FIG. 1 along a line A-A. In this embodiment, the electronic device 100 is a standard smartphone. Specifically, the electronic device 100 includes a screen 10, a housing 20, a circuit board 30, and a battery 40. Because the circuit board 30 and the battery 40 are invisible inside the electronic device 100, the circuit board 30 and the battery 40 in FIG. 1 are represented by dashed lines.

It may be understood that, FIG. 1, FIG. 2, and the following related accompanying drawings only schematically show some components included in the electronic device 100, and actual shapes, actual sizes, actual positions, and actual structures of the components are not limited in FIG. 1, FIG. 2, and the following accompanying drawings. In some other embodiments, alternatively, the electronic device 100 may not include the screen 10.

In the embodiment shown in FIG. 1, the electronic device 100 is in the shape of a rectangular flat plate. To facilitate descriptions of the following embodiments, an XYZ coordinate system is established. Specifically, a width direction of the electronic device 100 is defined as an X-axis direction, a length direction of the electronic device 100 is defined as a Y-axis direction, and a thickness direction of the electronic device 100 is defined as a Z-axis direction. It may be understood that the coordinate system of the electronic device 100 may be flexibly set according to an actual requirement. This is not specifically limited herein. In some other embodiments, a shape of the electronic device 100 may alternatively be a square flat plate shape, a circular flat plate, an oval flat plate, or the like.

The screen 10 is configured to display an image, a video, or the like. Refer to FIG. 2. The screen 10 includes a light-transmitting cover plate 11 and a display 12. The display 12 may be a flexible display, or may be a rigid display. The light-transmitting cover plate 11 and the display 12 are disposed in a stacked manner and fixedly connected. Specifically, the light-transmitting cover plate 11 and the display 12 are stacked on in the Z-axis direction. The light-transmitting cover plate 11 is mainly configured to protect the display 12 and prevent dust. The light-transmitting cover plate 11 may be a 2D cover plate, a 2.5D cover plate, or a 3D cover plate.

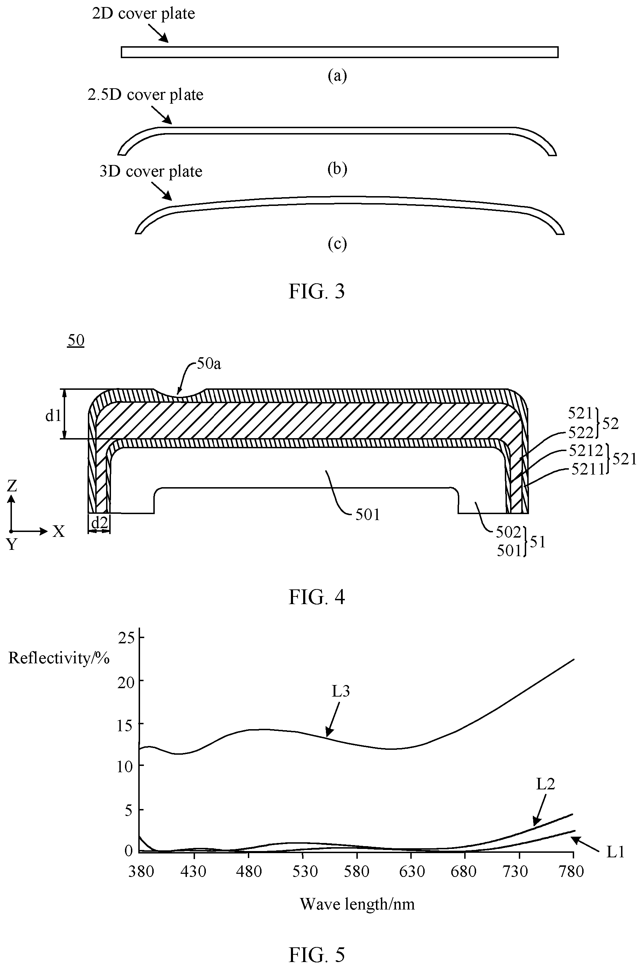

Refer to FIG. 3. FIG. 3 is a side view of different shapes of cover plates 50. Herein, (a) in FIG. 3 is a side view of a 2D cover plate, (b) in FIG. 3 is a side view of a 2.5D cover plate, and (c) in FIG. 3 is a side view of a 3D cover plate. Specifically, as shown in (a) in FIG. 3, the 2D cover plate is a common pure flat plate without any arc design. As shown in (b) in FIG. 3, a middle part of the 2.5D cover plate is a flat plate, but an edge has an arc design. Compared with the 2D cover plate, the 2.5D cover plate performs arc processing on the edge based on the flat plate cover plate. As shown in (c) in FIG. 3, the 3D cover plate uses an arc design at a middle part and an edge part of the cover plate. A curved design in the 3D cover plate may increase a visible area, better conforms to a curvature of a human retina, and provides better visual experience.

The housing 20 is configured to protect internal electronic components of the electronic device 100. Refer to FIG. 2. The housing 20 may include a back cover 21 and a frame 22. The frame 22 is located between the back cover 21 and the light-transmitting cover plate 11, and both the back cover 21 and the light-transmitting cover plate 11 are fixed on the frame 22 . The light-transmitting cover plate 11, the back cover 21, and the frame 22 enclose an internal accommodating space of the electronic device 100. The back cover 21 may be a 2D cover plate, a 2.5D cover plate, or a 3D cover plate.

In some embodiments, refer to FIG. 2. The housing 20 further includes a middle plate 23. The middle plate 23 is fixed around an inner surface of the frame 22. The middle plate 23 is used as a structural "support skeleton" of the electronic device 100, and the components such as the circuit board 30 and the battery 40 may be fixed to the middle plate 23.

Refer to FIG. 1. The circuit board 30 further includes a main circuit board 31 and an auxiliary circuit board 32. The main circuit board 31 may be configured to integrate a control chip. For example, the control chip may be an application processor (application processor, AP), a double data rate (double data rate, DDR) synchronous dynamic random access memory, a universal flash storage (UFS), or the like. In some embodiments, the main circuit board 31 is electrically connected to the screen 10.

The auxiliary circuit board 32 may be configured to integrate electronic components such as an antenna (such as a 5G antenna) radio frequency front end, a universal serial bus (universal serial bus, USB) component, an oscillator, and the like. The auxiliary circuit board 32 is electrically connected to the main circuit board 31. It may be understood that in another embodiment, the circuit board 30 may alternatively only include the main circuit board 31.

The battery 40 is configured to provide power to electronic components such as the display 12 and the circuit board 30 in the electronic device 100. In some embodiments, the battery 40 may be disposed between the main circuit board 31 and the auxiliary circuit board 32.

When the electronic device 100 is used without being adhered to a protective film, the cover plate, for example, the light-transmitting cover plate 11 or the back cover 21, generally has a scratch visible to the naked eye after the electronic device is used for approximately one month. In addition, as use time of the electronic device 100 is prolonged, there are more scratches on the cover plate. Stress balance of the cover plate may be damaged due to existence of these scratches, and consequently, impact resistance of the cover plate is reduced. At the same time, these scratches, or even a scratch that is not quite obvious, hinders visual effect and reduces a reputation of the electronic device 100. Moreover, because these scratches enhances scattering of light, when a scratch occurs on the light-transmitting cover plate 11, brightness, definition, and contrast of an image displayed on the screen 10 are greatly reduced, consequently affecting a display effect of the screen 10.

To improve scratch resistance of the cover plate, refer to FIG. 4. FIG. 4 is a diagram of a cross-sectional structure of the cover plate 50 in a related technology. The cover plate 50 includes a substrate 51 and a coating film layer 52. Specifically, the substrate 51 includes a middle part 501 and an edge part 502. The edge part 502 is arc-shaped. In other words, the cover plate 50 is a 3D cover plate or a 2.5D cover plate. The coating film layer 52 is disposed on an outer surface of the substrate 51. The "outer surface of the substrate 51" is a surface that is of the substrate 51 and that faces the outside of the electronic device 100.

The coating film layer 52 includes a scratch-resistant film layer 522 and an optical adjustment film layer 521. The optical adjustment film layer 521 includes an upper optical adjustment film layer 5211 and a lower optical adjustment film layer 5212. The lower optical adjustment film layer 5212 is disposed on a surface of a side that is of the scratch-resistant film layer 522 and that is close to the substrate 51, and the upper optical adjustment film layer 5211 is disposed on a surface of a side that is of the scratch-resistant film layer 522 and that faces away from the substrate 51. The upper optical adjustment film layer 5211 and the lower optical adjustment film layer 5212 both include at least one high-refractive-index film layer and at least one low-refractive-index film layer that are sequentially stacked and alternately disposed. A refractive index of the high-refractive-index film layer is greater than a refractive index of the low-refractive-index film layer. In this way, after being reflected and refracted by film layers of the upper optical adjustment film layer 5211 and the lower optical adjustment film layer 5212, light in a specific wave band is strengthened or weakened under interference of light, and may reduce reflectivity of the cover plate 50 for visible light, to adjust optical performance of the cover plate 50.

The scratch-resistant film layer 522 is composed of a high-hardness high-refractive-index material, and is a main film layer for improving the scratch resistance of the cover plate 50. To ensure the scratch resistance of the cover plate 50, a thickness of the scratch-resistant film layer 522 is usually greater than or equal to 500 nm.

The coating film layer 52 has strong scratch resistance, and can significantly improve the scratch resistance of the cover plate 50. Therefore, the cover plate 50 (for example, a glass cover plate) including the coating film layer 52 can satisfy a requirement of the external cover plate 50. In addition, the coating film layer 52 can reduce reflectivity of the substrate 51, improve a light-transmitting rate of the cover plate 50, and improve the optical performance of the cover plate 50. For example, when the substrate 51 is glass, reflectivity of the glass is approximately 8.4%, and a light-transmitting rate is approximately 92%. After the coating film layer 52 is disposed on a single side of the substrate 51 (that is, single-side coating), the reflectivity of the cover plate 50 can reach less than or equal to 5.2%, and the light-transmitting rate can reach greater than or equal to 95%. After the coating film layer 52 is disposed on both sides of the substrate 51 (that is, double-side coating), the reflectivity of the cover plate 50 can reach less than or equal to 1%, and the light-transmitting rate can reach greater than or equal to 98%.

However, the scratch-resistant film layer 522 is usually processed by using a sputtering (sputtering) technology. Sputtering is a process in which a target is bombarded by a charged particle, to enable a target atom to escape from a surface and deposit on a substrate material. However, the target has a poor electrical conductivity, which causes an electric charge to accumulate on a target surface. When the electric charge accumulates to a specific amount, the electric charge is released at a lowest point of target surface resistance, which causes an arc discharge phenomenon (also referred to as "target arcing"). Large-particle sputtering substances are generated at the same time, and are sputtered to the surface of the substrate 51. The large-particle sputtering substances easily fall off in a subsequent cleaning process, consequently forming pits 50a (commonly referred to as white spots) on the surface of the cover plate 50, and generating an appearance defect.

Specifically, when the scratch-resistant film layer 522 is deposited to a specific thickness, an electric charge accumulated on the target surface may be released, leading to "target arcing", and causing an appearance defect on the cover plate 50. In addition, a probability that an appearance defect is generated during a coating process linearly increases as a thickness of a film layer increases, leading to an increase in an appearance defect rate of the cover plate 50 and a decrease in a product yield. In other words, a larger thickness of the scratch-resistant film layer 522 indicates a larger probability of an appearance defect caused by "target arcing" on the cover plate 50. For example, when the cover plate 50 does not include the scratch-resistant film layer 522, an appearance yield of the cover plate 50 can reach greater than 95%. When the cover plate 50 includes the scratch-resistant film layer 522, and the thickness of the scratch-resistant film layer 522 reaches greater than 500 nm, the appearance yield of the cover plate 50 is reduced to less than 60%.

In addition, because materials in the scratch-resistant film layer 522 that can have a scratch resistance function are generally high-hardness materials, and the high-hardness materials all have high refractive indexes, which may be up to 1.9 or more. On the basis of this, to adjust an appearance color of the cover plate 50 to a target color, the optical adjustment film layer 521 needs to reach a specific thickness. For example, the target color may be colorless, and a corresponding a value and a corresponding b value of the target color in an (L*, a*, b*) colorimetric system is 0 and 0.

In this way, at different observation angles, optical thicknesses of the optical adjustment film layer 521 through which a light ray passes are different, in other words, optical paths of the light ray are different. In this case, the optical adjustment film layers 521 absorb light differently, and reflected light has different wave lengths. Therefore, at different observation angles, the cover plate 50 may present different colors, causing an angle discoloration problem. The essence of the angle discoloration problem is that a change of an incident angle (which may also be referred to as an observation angle) affects an optical thickness of a film layer, and the impact on the optical thickness of the film layer causes a shift of a wave length. The impact is especially prominent when the film layer is thick. Especially, when the cover plate 50 should be used as the light-transmitting cover plate 11, a light ray of the display 12 needs to be emitted through the light-transmitting cover plate 11, and the angle discoloration problem further affects a display effect of the screen 10. The incident angle is an included angle between an incident light ray and the normal of the cover plate 50.

Refer to FIG. 5. FIG. 5 is a diagram of changes of spectra of the cover plate 50 shown in FIG. 4 at different incident angles. A horizontal coordinate in FIG. 5 indicates a wave length of a light ray, and the unit is nm. A vertical coordinate is reflectivity, and the unit is %. In FIG. 5, a curve L1 is a spectrum of the cover plate 50 when the incident angle is 0°, a curve L2 is a spectrum of the cover plate 50 when the incident angle is 35°, and a curve L3 is a spectrum of the cover plate 50 when the incident angle is 70°.

It can be seen from FIG. 5 that a larger incident angle of the cover plate 50 indicates higher reflectivity of the cover plate 50 to a light ray and a more obvious angle discoloration problem.

In addition, the optical adjustment film layer 521 is usually formed by using a technology, for example, physical vapor deposition, chemical vapor deposition, or atomic deposition. When the cover plate 50 is a 3D cover plate or a 2.5D cover plate, refer to FIG. 4. A thickness d2 of the coating film layer 52 on the edge part 502 of the substrate 51 is less than a thickness d1 of the coating film layer 52 on the middle part 501 of the substrate 51. Therefore, a rainbow edge is easily generated at a junction between the middle part 501 and the edge part 502 of the cover plate 50 after coating is performed, affecting appearance of the cover plate 50 and the display effect of the screen 10.

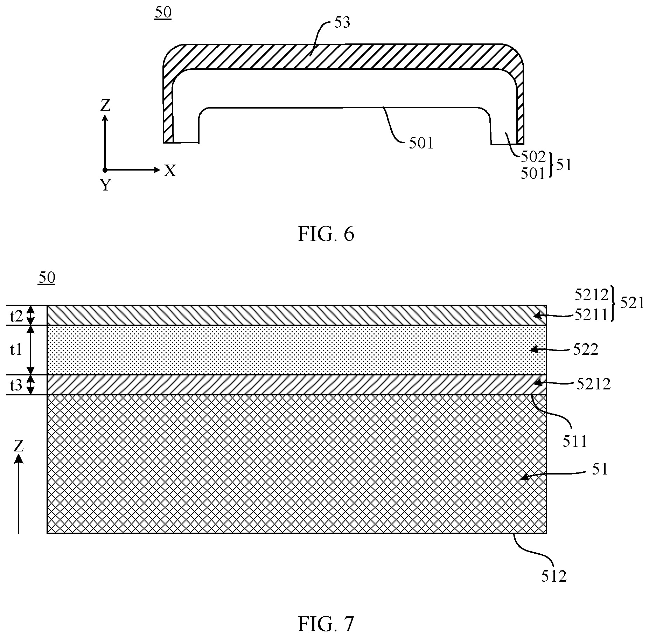

Refer to FIG. 6. FIG. 6 is a diagram of a cross-sectional structure of another cover plate 50 in a related technology. The cover plate 50 includes a substrate 51 and a diamond-like carbon (diamond-like carbon, DLC) film layer 53. The diamond-like carbon film layer 53 is disposed on a surface of the substrate 51.

Hardness of the diamond-like carbon film layer 53 is high, and Mohs hardness may reach 10, to improve overall hardness of the cover plate 50. In addition, a dynamic friction coefficient of the diamond-like carbon film layer 53 is low, and is generally less than 0.05, so that a user can have a smooth touch when touching the cover plate 50. This helps to improve user experience. Moreover, a physical thickness of the diamond-like carbon film layer 53 is thin, no appearance defect occurs during processing, and no angle discoloration problem and no rainbow edge problem occur when coating is performed on a 2.5D cover plate and a 3D cover plate.

However, because the diamond-like carbon film layer 53 includes black graphite molecules that strongly absorb light, a thickness of a film layer cannot be set to be large. Otherwise, optical performance of the cover plate 50 is affected.

Specifically, after the diamond-like carbon film layer 53 having a thickness of less than 15 nm is disposed on a glass substrate, a light-transmitting rate of the cover plate 50 is reduced to 90%. In addition, because the diamond-like carbon film layer 53 is thin in this case, the film layer is easily penetrated, and the scratch resistance of the cover plate 50 is not greatly improved.

Therefore, both scratch resistance and an appearance yield of the cover plate 50 in the related technology cannot be take into account. On the basis of this, to improve the appearance yield of the cover plate 50 while improving the scratch resistance of the cover plate 50, refer to FIG. 7. FIG. 7 is a partial cross-sectional view of the cover plate 50 according to some embodiments of this application. The cover plate 50 in this embodiment may be used as the light-transmitting cover plate 11 of the electronic device 100, or may be used as the back cover 21 of the electronic device 100. In the following embodiments, the cover plate 50 is used as the light-transmitting cover plate 11 of the electronic device 100 as an example for description.

Refer to FIG. 7. The cover plate 50 includes the substrate 51, an optical adjustment film layer 521, and a scratch-resistant film layer 522. The substrate 51 includes a first surface 511 and a second surface 512 that face opposite to each other in a thickness direction (that is, a Z-axis direction shown in FIG. 7) of the substrate 51. The first surface 511 may be an outer surface of the substrate 51, and the second surface 512 may be an inner surface of the substrate 51. In other words, the first surface 511 may face the outside of the electronic device 100, and the second surface 512 may face the inside of the electronic device 100.

In some embodiments, the substrate 51 may be a glass substrate. For example, the substrate 51 may be an inorganic glass system substrate such as a microcrystalline glass substrate, a soda-lime glass substrate, or an aluminosilicate glass substrate. In some other embodiments, the substrate 51 may alternatively be an organic substrate such as a polymethyl methacrylate (polymethyl methacrylate, PMMA) substrate or a polycarbonate (polycarbonate, PC) substrate. In still some other embodiments, the substrate 51 may alternatively be a ceramics substrate.

The scratch-resistant film layer 522 and the substrate 51 are disposed in a stacked manner. For example, the scratch-resistant film layer 522 may be disposed on the first surface 511 of the substrate 51. Specifically, the scratch-resistant film layer 522 may be directly formed on the first surface 511 of the substrate 51, or may be formed on a surface of another film layer located on the first surface 511 of the substrate 51. The scratch-resistant film layer 522 includes a silicon (Si) element and a doped element. The doped element can form a covalent bond with the silicon element, and the doped element does not include a nitrogen (N) element. It may be understood that the scratch-resistant film layer 522 may include the nitrogen element, or may not include the nitrogen element. When the scratch-resistant film layer 522 includes the nitrogen element, the nitrogen element is not considered as a doped element.

The doped element includes at least one element having a valence of +3 and/or at least one element having a valence of +5, and the doped element does not include the nitrogen element. Specifically, the doped element may include at least one element from Group 13 of the Periodic Table of the Elements and/or at least one element from Group 15 of the Periodic Table of the Elements, and the doped element does not include the nitrogen element. For example, the doped element may include at least one element of a boron (B) element, an aluminum (Al) element, a gallium (Ga) element, an indium (In) element, a thallium (Tl) element, a phosphorus (P) element, an arsenic (As) element, an antimony (Sb) element, and a tellurium (Te) element. The doped element may include one element, or may include a plurality of elements.

The doped element is used for forming a covalent bond with the silicon element. Because an outer layer of the silicon element includes four electrons and an outer layer of an element having a valence of +3 includes three electrons, a hole can be generated when the element having the valence of +3 forms a covalent bond with the silicon element. An outer layer of an element having a valence of +5 includes five electrons, and a free electron can be generated when the outer layer of element having the valence of +5 forms a covalent bond with the silicon element. Both the hole and the free electronic device can improve an electrical conductivity of a material.

In this way, when the scratch-resistant film layer 522 is processed, the doped element may be added to a silicon target, to improve an electrical conductivity of the silicon target, thereby effectively avoiding electric charge accumulation on a surface of the silicon target in a process of sputtering the scratch-resistant film layer 522. This helps to reduce a probability of generating an arc discharge phenomenon in the process of sputtering, and can further avoid generation of a large-particle sputtering substance in the process of sputtering, thereby effectively reducing a probability of forming a "white spot" on a surface of the cover plate 50, and improving an appearance yield of the cover plate 50. Therefore, on the cover plate 50 in this embodiment of this application, the scratch-resistant film layer 522 including the silicon element and the doped element is disposed, so that a "white spot" can be effectively prevented from being formed on the surface of the cover plate 50, thereby improving the appearance yield of the cover plate 50.

In some embodiments, a mass fraction w1 of the doped element in the scratch-resistant film layer 522 is greater than or equal to 0.2%. The mass fraction w1 of the doped element is a ratio of mass m1 of the doped element to total mass m of the scratch-resistant film layer 522. The mass fraction of the doped element may be measured by using an energy dispersive spectrum (energy dispersive spectrometer, EDS).

For example, the mass fraction w1 of the doped element may be 0.2%, 0.25%, 0.3%, 0.35%, 0.4%, 0.45%, 0.5%, 0.6%, 0.7%, 0.8%, 0.9%, 1.0%, 1.2%, 1.5%, 1.8%, 2.0%, 2.1%, 2.2%, 2.3%, 2.5%, 2.8%, 3.0%, 3.5%, 4%, or the like. In this way, the electrical conductivity of the silicon target can be effectively improved.

On the basis of this, to prevent the doped element from affecting the optical performance of the cover plate 50, the mass fraction w1 of the doped element in the scratch-resistant film layer 522 is less than or equal to 3%.

In some embodiments, a physical thickness t1 of the scratch-resistant film layer 522 is greater than or equal to 500 nm and less than or equal to 3000 nm. For example, the physical thickness t1 of the scratch-resistant film layer 522 may be 500 nm, 600 nm, 700 nm, 800 nm, 900 nm, 1000 nm, 1100 nm, 1200 nm, 1300 nm, 1400 nm, 1500 nm, 1600 nm, 1700 nm, 1750 nm, 1800 nm, 1850 nm, 1900 nm, 1950 nm, 2000 nm, 2100 nm, 2200 nm, 2300 nm, 2400 nm, 2500 nm, 2600 nm, 2700 nm, 2800 nm, 2900 nm, 3000 nm, or the like. In this way, a scratch resistance function of the scratch-resistant film layer 522 can be ensured, and an overall thickness of the cover plate 50 can be reduced.

It should be noted that the "physical thickness of the film layer" described in the embodiment of this application refers to a distance between a surface of a side of the film layer facing away from the substrate 51 and a surface of a side of the film layer facing the substrate 51.

In some embodiments, Vickers hardness (HV) of the scratch-resistant film layer 522 is greater than or equal to 1100 HV. Specifically, when hardness of the cover plate 50 including the scratch-resistant film layer 522 is tested by using a Vickers indenter, when a surface indentation depth of the cover plate 50 is approximately 100 nanometers (nm), measured Vickers hardness is greater than or equal to 1100 HV. For example, the Vickers hardness of the scratch-resistant film layer 522 may be 1100 HV, 1200 HV, 1300 HV, 1400 HV, 1500 HV, 1600 HV, 1700 HV, 1800 HV, 1900 HV, 2000 HV, 2200 HV, 2500 HV, 3000 HV, or the like. In this way, wear resistance, corrosion resistance, drop resistance, scratch resistance, and the like of the cover plate 50 can be improved, thereby helping to reduce a scratch on the cover plate 50. This can improve aesthetic appearance of the cover plate 50 and the electronic device 100 including the cover late 50, and prolong service lives of the cover plate 50 and the electronic device 100.

On the basis of any one of the foregoing embodiments, to resolve the angle discoloration problem and the rainbow edge problem of the cover plate 50, in some embodiments, the scratch-resistant film layer 522 includes a first material and a second material. In other words, the scratch-resistant film layer 522 is a mixture of a plurality of materials. The first material and the second material may be mixed at an atomic level. A refractive index of the first material is greater than or equal to a refractive index of the substrate 51, and a refractive index of the second material is less than or equal to the refractive index of the substrate 51. In this way, after the first material and the second material are mixed, a refractive index of the scratch-resistant film layer 522 can be adjusted, and a difference between the refractive index of the scratch-resistant film layer 522 and the refractive index of the substrate 51 can be reduced, thereby reducing difficulty in adjusting the optical performance and an appearance color of the cover plate 50, helping to thin a thickness of the optical adjustment film layer 521. This can further reduce a difference in optical thicknesses of the optical adjustment film layer 521 at different incident angles, and effectively improve the angle discoloration problem and the rainbow edge problem, so that the optical adjustment film layer 521 is not only applicable to a 2D cover plate, but also applicable to a 3D cover plate or a 2.5D cover plate.

Specifically, Vickers hardness of the first material may be greater than or equal to 1100 HV. For example, the Vickers hardness of the first material may be 1100 HV, 1200 HV, 1300 HV, 1400 HV, 1500 HV, 1600 HV, 1700 HV, 1800 HV, 1900 HV, 2000 HV, 2200 HV, 2500 HV, 3000 HV, or the like. In this way, the Vickers hardness of the scratch-resistant film layer 522 can be improved, thereby improving the wear resistance, the corrosion resistance, the drop resistance, the scratch resistance, and the like of the cover plate 50.

In some embodiments, the substrate 51 is a glass substrate, and the refractive index $n_k$ of the scratch-resistant film layer 522 is greater than or equal to 1.46 and less than or equal to 1.85. For example, the refractive index $n_k$ of the scratch-resistant film layer 522 may be 1.46, 1.5, 1.52, 1.58, 1.6, 1.62, 1.65, 1.7, 1.72, 1.75, 1.78, 1.8, 1.85. A refractive index $n_g$ of the glass substrate is approximately 1.52. By setting the refractive index $n_k$ of the scratch-resistant film layer 522 to be greater than or equal to 1.46 and less than or equal to 1.85, this can reduce the difference between the refractive index $n_k$ of the scratch-resistant film layer 522 and the refractive index $n_g$ of the substrate 51, so that a material of the scratch-resistant film layer 522 is approximately homogeneous with a material of the substrate 51, which can reduce difficulty in adjusting the optical performance and the appearance color of the cover plate 50. This helps to thin the thickness of the optical adjustment film layer 521, to effectively improve both the angle discoloration problem and the rainbow edge problem.

Furthermore, the refractive index $n_k$ of the scratch-resistant film layer 522 is greater than or equal to 1.65 and less than or equal to 1.85. In this way, when improving the angle discoloration problem and the rainbow edge problem, it is ensured that the scratch-resistant film layer 522 has high Vickers hardness.

In some embodiments, the first material may include at least one of silicon nitride ($Si_3N_4$), aluminum nitride (AlN), niobium oxide ($Nb_2O_5$), and titanium oxide ($TiO_2$), tantalum oxide ($Ta_2O_5$), and aluminum oxide ($Al_2O_3$). The second material may include at least one of silicon oxide ($SiO_2$), magnesium fluoride ($MgF_2$), and calcium fluoride ($CaF_2$). Optical performance of these materials are good, and can satisfy requirements for the refractive indexes of the first material and the second material. In addition, the materials have high Vickers hardness, and can increase the hardness of the optical adjustment film layer 521, thereby further improving the scratch resistance of the cover plate 50.

According to the Lorentz-Lorentz dispersion theory formula of a multi-material mixed refractive index and an ingredient proportion of a thin film, the refractive index $n_k$ of the scratch-resistant film layer 522 after a plurality of materials are mixed satisfies the following formula (1):

$$n_k{}^2 = \sum_{i=1}^{N} \left( \frac{a_i n_i{}^2 c_i}{\rho_i} \right) / \sum_{i=1}^{N} \left( \frac{a_i c_i}{\rho_i} \right) \quad (1)$$

Herein, N is a quantity of material types in the scratch-resistant film layer 522. Specifically, N is a sum of a quantity of material types in the first material and a quantity of material types in the second material: $a_i = (n_i{}^2 + 2)^{-1}$, $\rho_i$ is a density of the $i^{th}$ material, $C_i$ is a mass fraction of the $i^{th}$ material, and $n_i$ is a refractive index of the $i^{th}$ material. The refractive index $n_k$ of the scratch-resistant film layer 522 can be calculated based on mass fractions of different materials in a mixture.

For example, when the first material includes one material and the second material includes one material, a mass fraction of the first material is $c_H$, a density of the first material is $\rho_H$, and a refractive index of the first material is $n_H$; and a mass fraction of the second material is $c_L$, a density of the second material is $\rho_L$, and a refractive index of the second material is $n_L$. A sum of the mass fraction $c_H$ of the first material and the mass fraction $c_L$ of the second material is 1, therefore $c_L = 1 - c_H$. Substitute $c_L = 1 - c_H$ into the formula (1), the formula (1) can be simplified to the following formula (2):

$$n_k{}^2 = \frac{\dfrac{n_L{}^2}{\rho_L} \bullet \left( \dfrac{1}{c_H} - 1 \right) + \dfrac{n_{II}{}^2}{\rho_H} \bullet \dfrac{a_{II}}{a_L}}{\dfrac{1}{\rho_L} \bullet \left( \dfrac{1}{c_H} - 1 \right) + \dfrac{1}{\rho_H} \bullet \dfrac{a_H}{a_L}} \quad (2)$$

For example, in some embodiments, the first material is silicon nitride ($Si_3N_4$), and the second material is silicon oxide ($SiO_2$). A substance formed by atomic-level mixing of the first material and the second material may be referred to as silicon oxynitride ($SiO_xN_y$), and the refractive index $n_k$ of the scratch-resistant film layer 522 can be adjusted by adjusting a mass ratio of silicon nitride to silicon oxide. Herein, x and y are both positive numbers. For another example, in some other embodiments, the first material is aluminum oxide ($Al_2O_3$), and the second material is silicon oxide ($SiO_2$). A substance formed by atomic-level mixing of the first material and the second material may be referred to as aluminum oxynitride ($AlO_mN_n$), and the refractive index $n_k$ of the scratch-resistant film layer 522 can be adjusted by adjusting a mass ratio of aluminum oxide to silicon oxide. Herein, m and n are both positive numbers.

Specifically, the refractive index $n_k$ of the scratch-resistant film layer 522 corresponding to different mass fractions of silicon nitride when the first material is silicon nitride ($Si_3N_4$) and the second material is silicon oxide ($SiO_2$) and the refractive index $n_k$ of the scratch-resistant film layer 522 corresponding to different mass fractions of aluminum oxide when the first material is aluminum oxide ($Al_2O_3$) and the second material is silicon oxide ($SiO_2$) are shown in Table 1.

**Table 1**

| Mass fraction of the first material | Refractive index $n_k$ of the scratch-resistant film layer 522 | | | |
| --- | --- | --- | --- | --- |
| | $Si_3N_4$-$SiO_2$ | | $Al_2O_3$-$SiO_2$ | |
| | First material $Si_3N_4$ | Second material $SiO_2$ | First material $Al_2O_3$ | Second material $SiO_2$ |
| 10% | 1.49 | | 1.47 | |
| 20% | 1.52 | | 1.49 | |
| 30% | 1.56 | | 1.50 | |
| 40% | 1.61 | | 1.52 | |
| 50% | 1.66 | | 1.54 | |
| 60% | 1.71 | | 1.56 | |
| 70% | 1.78 | | 1.59 | |
| 80% | 1.85 | | 1.62 | |

(continued)

| Mass fraction of the first material | Refractive index $n_k$ of the scratch-resistant film layer 522 | | | |
|---|---|---|---|---|
| | Si₃N₄-SiO₂ | | Al₂O₃-SiO₂ | |
| | First material Si₃N₄ | Second material SiO₂ | First material Al₂O₃ | Second material SiO₂ |
| 90% | 1.95 | | 1.65 | |
| 100% | 2.06 | | 1.70 | |

It can be seen from Table 1 that, when the first material is silicon nitride ($Si_3N_4$) and the second material is silicon oxide ($SiO_2$), and the mass fraction of silicon nitride is greater than or equal to 10% and less than or equal to 80%, the refractive index $n_k$ of the scratch-resistant film layer 522 may be controlled to 1.49 to 1.85, which can reduce the difference between the refractive index of the scratch-resistant film layer 522 and the refractive index of the substrate 51, enabling the scratch-resistant film layer 522 to be approximately homogeneous with the substrate 51. This helps to thin the thickness of the optical adjustment film layer 521, and can effectively improve the angle discoloration problem and the rainbow edge problem of the cover plate 50.

Further, when the first material is silicon nitride ($Si_3N_4$) and the second material is silicon oxide ($SiO_2$), and the mass fraction of silicon nitride is greater than or equal to 10% and less than or equal to 50%, the refractive index $n_k$ of the scratch-resistant film layer 522 may be controlled to 1.49 to 1.66, which can further reduce the difference between the refractive index of the scratch-resistant film layer 522 and the refractive index of the substrate 51, enabling the scratch-resistant film layer 522 to be more approximately homogeneous with the substrate 51. This helps to further thin the thickness of the optical adjustment film layer 521, and can further improve the angle discoloration problem and the rainbow edge problem of the cover plate 50.

When the first material is aluminum oxide ($Al_2O_3$) and the second material is silicon oxide ($SiO_2$), and the mass fraction of aluminum oxide is greater than or equal to 10% and less than 100%, the refractive index $n_k$ of the scratch-resistant film layer 522 may be controlled to 1.47 to 1.7, which can reduce the difference between the refractive index of the scratch-resistant film layer 522 and the refractive index of the substrate 51, enabling the scratch-resistant film layer 522 to be approximately homogeneous with the substrate 51. This helps to thin the thickness of the optical adjustment film layer 521, and can effectively improve the angle discoloration problem and the rainbow edge problem of the cover plate 50.

Further, when the first material is aluminum oxide ($Al_2O_3$) and the second material is silicon oxide ($SiO_2$), and the mass fraction of aluminum oxide is greater than or equal to 20% and less than 80%, the refractive index of the scratch-resistant film layer may be controlled to 1.49 to 1.62, which can further reduce the difference between the refractive index of the scratch-resistant film layer 522 and the refractive index of the substrate 51, enabling the scratch-resistant film layer 522 to be more approximately homogeneous with the substrate 51. This helps to further thin the thickness of the optical adjustment film layer 521, and can further improve the angle discoloration problem and the rainbow edge problem of the cover plate 50.

In some embodiments, refer to FIG. 7. The optical adjustment film layer 521 includes an upper optical adjustment film layer 5211 and a lower optical adjustment film layer 5212. The upper optical adjustment film layer 5211 is disposed on a surface of a side that is of the scratch-resistant film layer 522 and that faces away from the substrate 51. The lower optical adjustment film layer 5212 is disposed on a surface of a side that is of the scratch-resistant film layer 522 and that is close to the substrate 51. A material of the optical adjustment film layer 521 may be a dielectic material. Optionally, the upper optical adjustment film layer 5211 and the lower optical adjustment film layer 5212 are both colorless transparent film layers.

A person skilled in the art of optics may design a film system of the optical adjustment film layer 521 on optical film software (such as TFCall software and Macleod software). It may be understood that, in another embodiment, the optical adjustment film layer 521 may include only the upper optical adjustment film layer 5211 instead of the lower optical adjustment film layer 5212, or the optical adjustment film layer 521 may include only the lower optical adjustment film layer 5212 instead of the upper optical adjustment film layer 5211.

Specifically, in some embodiments, the upper optical adjustment film layer 5211 is a single-layer film layer, and a refractive index of the upper optical adjustment film layer 5211 is less than the refractive index of the scratch-resistant film layer 522. In this way, by designing the upper optical adjustment film layer 5211 as a single-layer film system, a structure of the upper optical adjustment film layer 5211 can be simplified, and a total thickness of the optical adjustment film layer 521 can be reduced, thereby reducing a difference between optical thicknesses of the optical adjustment film layer 521 at different incident angles, and improving the angle discoloration problem and the rainbow edge problem. In addition, the scratch-resistant film layer 522 and the upper optical adjustment film layer 5211 may form a composite film layer with a high-refractive-index film layer and a low-refractive-index film layer that are superimposed. Light rays reflected and refracted by the scratch-resistant film layer 522 and the upper optical adjustment film layer 5211 interfere with each other, so that reflectivity of light in a specific wave band in an emergent light ray can be enhanced, and a light-transmitting rate of the cover plate 50 can be further improved, to optimize the optical performance of the cover plate 50 and adjust the appearance color of the cover plate 50.

In some embodiments, the refractive index of the upper optical adjustment film layer 5211 is greater than or equal to 1.55 and less than or equal to 1.65. For example, the refractive index of the upper optical adjustment film layer 5211 may be 1.55, 1.56, 1.57, 1.58, 1.59, 1.6, 1.61, 1.62, 1.63, 1.64, 1.65, or the like. In this way, this helps to reduce the difference between optical thicknesses of the upper optical adjustment film layer 5211 at different incident angles, thereby improving the angle discoloration problem and the rainbow edge problem of the cover plate 50.

In some embodiments, the upper optical adjustment film layer 5211 may include one or more materials. When the upper optical adjustment film layer 5211 includes a plurality of materials, the upper optical adjustment film layer 5211 includes at least one high-refractive-index material and at least one low-refractive-index material. A refractive index of the high-refractive-index material is greater than a refractive index of the low-refractive-index material. In this way, by adjusting a mass ratio of the high-refractive-index material to the low-refractive-index material, the upper optical adjustment film layer 5211 has a corresponding refractive index, to reduce difficulty in processing the upper optical adjustment film layer 5211.

In some embodiments, the refractive index of the high-refractive-index material is greater than or equal to 1.6, and the refractive index of the low-refractive-index material is greater than or equal to 1.4 and less than 1.6. In this way, the high-refractive-index material and the low-refractive-index material are both easily obtained, and are convenient to satisfy a requirement of the upper optical adjustment film layer 5211 for a refractive index.

For example, the high-refractive-index material may be silicon nitride ($Si_3N_4$), aluminum nitride (AlN), niobium oxide ($Nb_2O_5$), titanium oxide ($TiO_2$), tantalum oxide ($Ta_2O_5$), zirconium oxide (ZrN), silicon oxynitride ($SiO_xN_y$), aluminum oxynitride ($AlO_mN_n$), or the like. The low-refractive-index material may be silicon oxide ($SiO_2$), magnesium fluoride ($MgF_2$), or the like. Optical performance of these materials is good, and can satisfy a requirement for a refractive index. In addition, these materials are easily obtained, and can reduce difficulty in processing the upper optical adjustment film layer 5211.

In some embodiments, refer to FIG. 7. A physical thickness t2 of the upper optical adjustment film layer 5211 is less than or equal to 300 nm. Further, the physical thickness t2 of the upper optical adjustment film layer 5211 is greater than or equal to 30 nm. For example, the physical thickness t2 of the upper optical adjustment film layer 5211 may be 300 nm, 280 nm, 260 nm, 250 nm, 240 nm, 220 nm, 200 nm, 180 nm, 160 nm, 150 nm, 130 nm, 120 nm, 100 nm, 90 nm, 80 nm, 70 nm, 60 nm, 50 nm, 30 nm, or the like. In this way, the difference between optical thicknesses of the upper optical adjustment film layer 5211 at different incident angles can be reduced, thereby improving the angle discoloration problem and the rainbow edge problem of the cover plate 50.

On the basis of any one of the foregoing embodiments, a ratio B1 of the physical thickness t1 of the scratch-resistant film layer 522 to the physical thickness t2 of the upper optical adjustment film layer 5211 is greater than or equal to 10. Further, B1 is greater than or equal to 10. For example, B1 may alternatively be 10, 11, 12, 13, 14, 15, 16, 17, 18, 19, 20, 21, 22, 23, 25, 26, 30, 35, 40, 50, 60, 70, or the like. In this way, there is a large difference between the thicknesses of the scratch-resistant film layer 522 and the upper optical adjustment film layer 5211, so that the scratch-resistant film layer 522 and the upper optical adjustment film layer 5211 may be considered as a single-layer film system as a whole, thereby further improving the angle discoloration problem and the rainbow edge problem of the cover plate 50.

In some embodiments, the lower optical adjustment film layer 5212 is a single-layer film layer, and a refractive index of the lower optical adjustment film layer 5212 is less than the refractive index of the scratch-resistant film layer. In this way, by designing the lower optical adjustment film layer 5212 as a single-layer film system, a structure of the lower optical adjustment film layer 5212 can be simplified, and the total thickness of the optical adjustment film layer 521 can be reduced, thereby reducing the difference between optical thicknesses of the optical adjustment film layer 521 at different incident angles, and improving the angle discoloration problem and the rainbow edge problem of the cover plate 50. In addition, the scratch-resistant film layer 522 and the lower optical adjustment film layer 5212 may form a composite film layer with a high-refractive-index film layer and a low-refractive-index film layer that are superimposed. Light rays reflected and refracted by the scratch-resistant film layer 522 and the lower optical adjustment film layer 5212 interfere with each other, so that reflectivity of light of a specific wave length in an emergent light ray can be enhanced, and a light-transmitting rate of the cover plate 50 can be further improved, to optimize the optical performance of the cover plate 50 and adjust the appearance color of the cover plate 50.

In some embodiments, the refractive index of the lower optical adjustment film layer 5212 is greater than or equal to 1.55 and less than or equal to 1.65. For example, the refractive index of the lower optical adjustment film layer 5212 may be 1.55, 1.56, 1.57, 1.58, 1.59, 1.6, 1.61, 1.62, 1.63, 1.64, 1.65, or the like. In this way, this helps to reduce a difference between optical thicknesses of the lower optical adjustment film layer 5212 at different incident angles, and improve the angle discoloration problem and the rainbow edge problem of the cover plate 50. In addition, these materials are easily obtained, and can reduce difficulty in processing the cover plate 50.

The lower optical adjustment film layer 5212 may include one or more materials. When the lower optical adjustment film layer 5212 includes a plurality of materials, the lower optical adjustment film layer 5212 includes at least one high-refractive-index material and at least one low-refractive-index material. A refractive index of the high-refractive-index material is greater than a refractive index of the low-refractive-index material. For the material of the lower optical adjustment film layer 5212, refer to the material of the upper optical adjustment film layer 5211 for design, and details are not described herein again. In addition, it may be understood that the material of the lower optical adjustment film layer 5212 may be the same as the material of the upper optical adjustment film layer 5211, or may be different from the material of the upper optical adjustment film layer 5211.

In some embodiments, refer to FIG. 7. A physical thickness t3 of the lower optical adjustment film layer 5212 is less than or equal to 300 nm. Further, the physical thickness t3 of the upper optical adjustment film layer 5211 is greater than or equal to 30 nm. For example, the physical thickness t3 of the lower optical adjustment film layer 5212 may be 300 nm, 280 nm, 260 nm, 250 nm, 240 nm, 220 nm, 200 nm, 180 nm, 160 nm, 150 nm, 130 nm, 120 nm, 100 nm, 90 nm, 80 nm, 70 nm, 60 nm, 50 nm, 30 nm, or the like. In this way, this can help to reduce the difference between optical thicknesses of the lower optical adjustment film layer 5212 at different incident angles, and improve the angle discoloration problem and the rainbow edge problem of the cover plate 50.

A ratio B2 of the physical thickness t1 of the scratch-resistant film layer 522 to the physical thickness t3 of the lower optical adjustment film layer 5212 is greater than or equal to 10. For example, B2 may be 10, 11, 12, 13, 14, 15, 16, 17, 18, 19, 20, 21, 22, 23, 25, 26, 30, 35, 40, 50, 60, 70, or the like. In this way, there is a large difference between the thicknesses of the scratch-resistant film layer 522 and the lower optical adjustment film layer 5212, so that the scratch-resistant film layer 522 and the lower optical adjustment film layer 5212 may be considered as a single-layer film system as a whole, thereby further improving the angle discoloration problem and the rainbow edge problem of the cover plate 50.

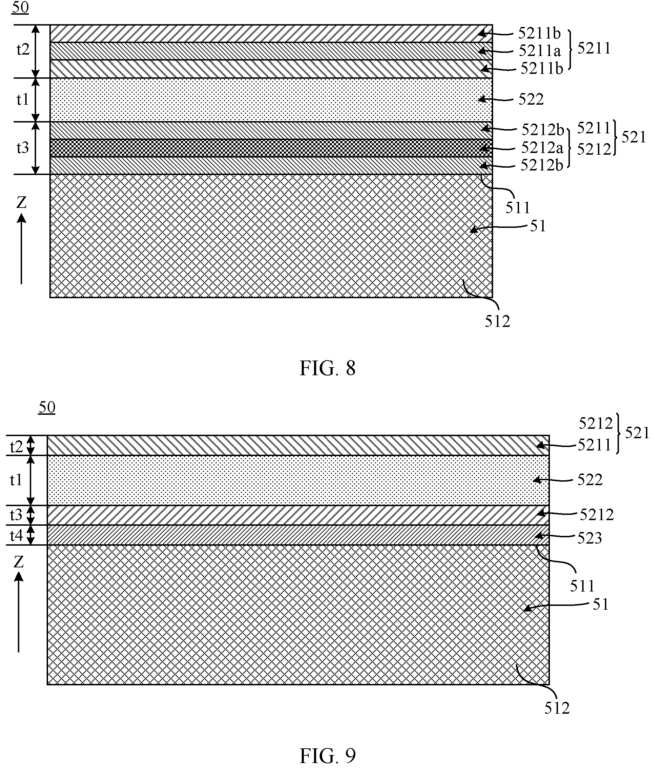

In some embodiments, refer to FIG. 8. FIG. 8 is a partial cross-sectional view of a cover plate 50 according to some other embodiments of this application. A difference between the cover plate 50 in this embodiment and the cover plate 50 in the embodiment shown in FIG. 7 lies in that, an upper optical adjustment film layer 5211 of the cover plate 50 in this embodiment includes at least one first high-refractive-index film layer 5211a and at least one first low-refractive-index film layer 5211b that are sequentially stacked and alternately disposed. A refractive index of the first high-refractive-index film layer 5211a is greater than a refractive index of the first low-refractive-index film layer 5211b.

Specifically, there may be one or more first high-refractive-index film layers 5211a. When there are a plurality of first high-refractive-index film layers 5211a, refractive indexes of the plurality of first high-refractive-index film layers 5211a may be the same or may be different. Similarly, there may be one or more first low-refractive-index film layers 5211b. When there are a plurality of first low-refractive-index film layers 5211b, refractive indexes of the plurality of first low-refractive-index film layers 5211b may be the same or may be different.

During actual application, thicknesses and refractive indexes of film layers in the upper optical adjustment film layer 5211 may be designed, so that different emergent light rays interfere with each other, to adjust optical performance and an appearance color of the cover plate 50. A specific structural design of the upper optical adjustment film layer 5211 may be performed on optical software (such as TFCall software and Macleod software).

Further, refer to FIG. 8. A film layer that is in the upper optical adjustment film layer 5211 and that is closest to a scratch-resistant film layer 522 is the first low-refractive-index film layer 5211b, and the refractive index of the first low-refractive-index film layer 5211b that is in the upper optical adjustment film layer 5211 and that is closest to the scratch-resistant film layer 522 is less than a refractive index of the scratch-resistant film layer 522. In this way, the scratch-resistant film layer 522 and the upper optical adjustment film layer 5211 may form a high-refractive-index film layer and a low-refractive-index film layer that are alternately disposed. Light rays reflected and refracted by the scratch-resistant film layer 522 and the upper optical adjustment film layer 5211 interfere with each other, so that reflectivity of light of a specific wave length in an emergent light ray can be enhanced, and a light-transmitting rate of the cover plate 50 can be further improved, to optimize optical performance of the cover plate 50 and adjust an appearance color of the cover plate 50.

In some embodiments, continue to refer to FIG. 8. A lower optical adjustment film layer 5212 includes at least one second high-refractive-index film layer 5212a and at least one second low-refractive-index film layer 5212b that are sequentially stacked and alternately disposed. A refractive index of the second high-refractive-index film layer 5212a is greater than a refractive index of the second low-refractive-index film layer 5212b.

Refer to FIG. 8. A film layer that is in the lower optical adjustment film layer 5212 and that is closest to the scratch-resistant film layer 522 is the second low-refractive-index film layer 5212b, and the refractive index of the second low-refractive-index film layer 5212b that is in the lower optical adjustment film layer 5212 and that is closest to the scratch-resistant film layer 522 is less than the refractive index of the scratch-resistant film layer 522. In this way, the scratch-resistant film layer 522 and the lower optical adjustment film layer 5212 may form a high-refractive-index film layer and a low-refractive-index film layer that are alternately disposed. Light rays reflected and refracted by the scratch-resistant film layer 522 and the upper optical adjustment film layer 5211 interfere with each other, so that reflectivity of light of a specific wave length in an emergent light ray can be enhanced, and a light-transmitting rate of the cover plate 50 can be further improved, to optimize the optical performance of the cover plate 50 and adjust the appearance color of the cover plate 50.

It may be understood that, the upper optical adjustment film layer 5211 in this embodiment may be applied to the cover plate 50 in any embodiment of this application. Similarly, the lower optical adjustment film layer 5212 in this embodiment may be applied to the cover plate 50 in any embodiment of this application.

Refer to FIG. 9. FIG. 9 is a partial cross-sectional view of a cover plate 50 according to some other embodiments of this application. In this embodiment, in addition to a substrate 51, a scratch-resistant film layer 522, and an optical adjustment film layer 521, the cover plate 50 further includes a primer layer 523. The primer layer 523 may be disposed in a stacked manner on a surface that is of the substrate 51 and that faces the scratch-resistant film layer 522. For example, the primer layer 523 may be disposed between a first surface 511 of the substrate 51 and a lower optical adjustment film layer 5212.

A material of the primer layer 523 includes at least one of aluminum, chromium, titanium, silicon, and silicon oxide. The primer layer 523 is used for increasing an adhesion force between the substrate 51 and a film layer that is closest to the first surface 511 of the substrate 51, and can effectively prevent a film layer on the substrate 51 from falling off. In addition, the primer layer 523 can further provide an etch-stop interface for removing a bad product film layer, to prevent a removal solution from damaging the substrate 51. The primer layer 523 in this embodiment may be applied to the cover plate 50 in any embodiment of this application.

There may be one or more primer layers 523. During actual application, a specific material and a quantity of layers of the primer layer 523 may be selected based on a material of the substrate 51. For example, when the material of the substrate 51 is glass or a ceramic, the primer layer 523 may be set to one layer, and the material of the primer layer 523 includes silicon oxide (SiO2). When the material of the substrate 51 is plastic, the primer layer 523 may be set to one layer, and the primer layer 523 includes elemental silicon (Si). When the material of the substrate 51 is stainless steel, the primer layer 523 may be set to one layer, and the material of the primer layer 523 includes chromium silicon. When the material of the substrate 51 is an aluminum alloy, the primer layer 523 may set to two layers. In this case, the primer layer 523 includes a first primer layer and a second primer layer. The first primer layer is disposed on the first surface 511 of the substrate 51, and the second primer layer is disposed on a surface of a side that is of the first primer layer and that faces away from the substrate 51. A material of the first primer layer includes metal aluminum, and a material of the second primer layer includes metal chromium (Gr). When the material of the substrate 51 is titanium alloy, the primer layer 523 may be set to one layer, and the material of the primer layer 523 includes metal titanium.

In some embodiments, refer to FIG. 9. A physical thickness t4 of the primer layer 523 is greater than or equal to 10 nm and less than or equal to 50 nm. Specifically, the physical thickness t4 of the primer layer 523 may be 10 nm, 15 nm, 20 nm, 25 nm, 30 nm, 35 nm, 40 nm, 45 nm, or 50 nm. In this way, the physical thickness t4 of the primer layer 523 is proper, so that an adhesion force between the lower optical adjustment film layer 5212 and the substrate 51 can be increased, and an overall thickness of the cover plate 50 can be reduced.

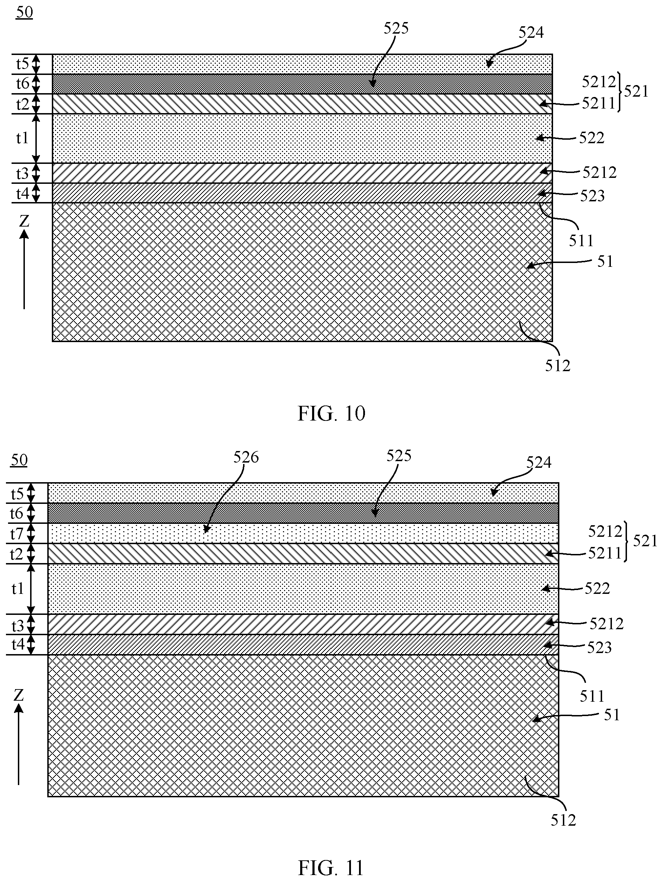

On the basis of any of the foregoing embodiments, to make an appearance surface of the cover plate 50 have anti-fingerprint performance, in some embodiments, refer to FIG. 10. FIG. 10 is a partial cross-sectional view of a cover plate 50 according to still other embodiments of this application. In this embodiment, in addition to a substrate 51, a scratch-resistant film layer 522, an optical adjustment film layer 521, and a primer layer 523, the cover plate 50 further includes an anti-fingerprint (AF) layer 524. The anti-fingerprint layer 524 in this embodiment may be applied to the cover plate 50 in any embodiment of this application.

Refer to FIG. 10. The anti-fingerprint layer 524 is disposed on a side that is the scratch-resistant film layer 522 and that faces away from the substrate 51. Specifically, the anti-fingerprint layer 524 may be disposed on a surface that is of an upper optical adjustment film layer 5211 and that faces away from the substrate 51. The anti-fingerprint layer 524 includes an organic or inorganic material with low surface energy and has lyophobic and oleophobic properties, so that a surface of the cover plate 50 is easy to clean and has good fingerprint resistance. Specifically, a material of the anti-fingerprint layer 524 includes, but is not limited to, a compound containing fluorine. For example, the material of the anti-fingerprint layer 524 may be polytetrafluoroethylene (polytetrafluoroethylene, PTFE), cloflucarban (cloflucarban), or the like. The compound containing fluorine has low surface energy, and can achieve purposes of being hydrophobic, oleophobic, and anti-fingerprint.

Refer to FIG. 10. A physical thickness t5 of the anti-fingerprint layer 524 is greater than 0 nm and less than or equal to 50 nm. For example, the physical thickness t5 of the anti-fingerprint layer 524 may be 2 nm, 3 nm, 5 nm, 8 nm, 10 nm, 12 nm, 15 nm, 16 nm, 18 nm, 20 nm, 22 nm, 25 nm, 28 nm, 29 nm, 30 nm, 32 nm, 35 nm, 38 nm, 40 nm, 42 nm, 45 nm, 48 nm, 50 nm, or the like. In this way, an overall thickness of the cover plate 50 can be reduced while a protective function of the anti-fingerprint layer 524 is ensured.

On the basis of this, to improve an adhesion force between the anti-fingerprint layer 524 and the upper optical adjustment film layer 5211, continue to refer to FIG. 10. A transition layer 525 is provided between the upper optical adjustment film layer 5211 and the anti-fingerprint layer 524. A material of the transition layer 525 may include silicon oxide ($SiO_2$).

Refer to FIG. 10. A physical thickness t6 of the transition layer 525 is greater than 0 nm and less than or equal to 50 nm. For example, the physical thickness t6 of the transition layer 525 may be 2 nm, 3 nm, 5 nm, 8 nm, 10 nm, 12 nm, 15 nm, 16 nm, 18 nm, 20 nm, 22 nm, 25 nm, 28 nm, 29 nm, 30 nm, 32 nm, 35 nm, 38 nm, 40 nm, 42 nm, 45 nm, 48 nm, 50 nm, or the like. In this way, the overall thickness of the cover plate 50 can be reduced while an adhesion force between the anti-fingerprint layer 524 and a lower optical adjustment film layer 5212 is improved.

Certainly, it may be understood that, in another embodiment, the cover plate 50 may not include the foregoing transition layer 525.

In some other embodiments, refer to FIG. 11. FIG. 11 is a partial cross-sectional view of a cover plate 50 according to still other embodiments of this application. In this embodiment, in addition to a substrate 51, a scratch-resistant film layer 522, an optical adjustment film layer 521, a primer layer 523, and an anti-fingerprint layer 524, the cover plate 50 further includes a hard slip layer 526. The hard slip layer 526 in this embodiment may be applied to the cover plate 50 in any embodiment of this application.

The hard slip layer 526 is used for reducing a dynamic friction coefficient of a surface of the cover plate 50, and reducing a shear force on the surface of the cover plate 50 when the surface of the cover plate 50 is rubbed. The hard slip layer 526 is disposed on a side that is of the scratch-resistant film layer 522 and that faces away from the substrate 51. Specifically, the hard slip layer 526 may be disposed on a surface of a side that is of an upper optical adjustment film layer 5211 and that faces away from the substrate 51. It may be understood that, in another embodiment, the hard slip layer 526 may alternatively be directly disposed on a surface of the side that is of the scratch-resistant film layer 522 and that faces away from the substrate 51.

In some embodiments, a dynamic friction coefficient of the hard slip layer 526 is less than or equal to 0.05. For example, the dynamic friction coefficient of the hard slip layer 526 may be 0.05, 0.04, 0.03, 0.02, 0.01, or the like. When a user touches the cover plate 50, a friction force is generated between a finger and the cover plate 50. The friction force can damage the film layers of the cover plate 50. According to a friction formula: $f=\mu\times Fn$, where is f the friction force, Fn is a normal pressure, and $\mu$ is a coefficient of friction. Therefore, by setting the dynamic friction coefficient of the hard slip layer 526 to be less than or equal to 0.05, a friction force on the surface of the cover plate 50 can be reduced, and damage to the film layers of the cover plate 50 can be avoided when the user touches the cover plate 50. In addition, the user can have a smooth touch when touching the cover plate 50. This helps to improve user experience.

Further, the dynamic friction coefficient of the hard slip layer 526 may be greater than or equal to 0.01. In this way, a material of the hard slip layer 526 can be easily obtained, and difficulty in processing the hard slip layer 526 can be reduced.

In some embodiments, the hard slip layer 526 includes one or more carbon materials containing $SP_2$ bonds. For example, the material of the hard slip layer 526 includes one or more of diamond-like carbon (DLC), graphite, and carbon nitride (CN). These materials have high hardness, can satisfy a requirement of the hard slip layer 526 for the dynamic friction coefficient, and can further improve wear resistance, scratch resistance, and the like of the cover plate 50 while reducing the friction force on the surface of the cover plate 50.

In some embodiments, refer to FIG. 11. A physical thickness t7 of the hard slip layer 526 is less than or equal to 200 nm. Further, the physical thickness t7 of the hard slip layer 526 is less than or equal to 50 nm. For example, the physical thickness t7 of the hard slip layer 526 may be 200 nm, 180 nm, 150 nm, 120 nm, 100 nm, 80 nm, 60 nm, 50 nm, 40 nm, 30 nm, 20 nm, 10 nm, 9 nm, 8 nm, 7 nm, 6 nm, 5 nm, or the like. In this way, optical performance of the cover plate 50 can be ensured while the friction force on the surface of the cover plate 50 is reduced.

The cover plate 50 in this embodiment of this application has the following advantages:

(1) An appearance defect rate caused by "target arcing" can be reduced by 80%, which can greatly improve a production yield of a hard coating section.

(2) The cover plate 50 has a light-transmitting rate greater than or equal to 85% and reflectivity less than or equal to 15% in a wave band of 380 nm to 780 nm measured by a spectrophotometer, and has excellent optical performance.

(3) A hardness test is performed on the cover plate 50 by using a Vickers indenter. When a surface indentation depth on the surface of the cover plate 50 is approximately 100 nanometers, measured Vickers hardness is greater than or equal to 1100 HV. A hardness test is performed on the cover plate 50 by using a Mohs hardness pen. Under a force of 500 g, Mohs hardness is greater than 7. The cover plate 50 has high hardness and strong scratch resistance and puncture resistance.

(4) According to the International Commission on Illumination, under a condition of normal incidence, in an (L*, a*, b*) colorimetric system, when the cover plate 50 is tested by using a colorimeter, in reflection color values of the cover plate 50, a value a is greater than or equal to -2 and less than or equal to 2, and a value b is greater than or equal to -2 and less than or equal to 2; and in transmission color values, a value a is greater than or equal to -2 and less than or equal to 2, and a value b is greater than or equal to -2 and less than or equal to 2. Under a condition of an incident angle of 60°, in the (L*, a*, b*) colorimetric system, when the cover plate 50 is tested by using a colorimeter, in the reflection color values of the cover plate 50, the value a is greater than or equal to -2 and less than or equal to 2, and the value b is greater than or equal to -2 and less than or equal to 2. The cover plate 50 has a good appearance color, and can be coated on a 2.5D cover plate 50 and a 3D cover plate 50. In addition, even if an arc surface of an edge part of the cover plate 50 reaches 90°, there is no angle discoloration problem or rainbow edge problem.

(5) The dynamic friction coefficient on the surface of the cover plate 50 is less than or equal to 0.05. After a cyclic test by using a Minorle eraser under a force of 1000 g, a speed of 40 cycles/min, and a test stroke of 4200 cycles, a water drop contact angle is >100°. This can prevent damage to the film layers of the cover plate 50 when the user touches cover plate 50. In addition, the user can have a smooth touch when touching the cover plate 50. This helps to improve user experience.

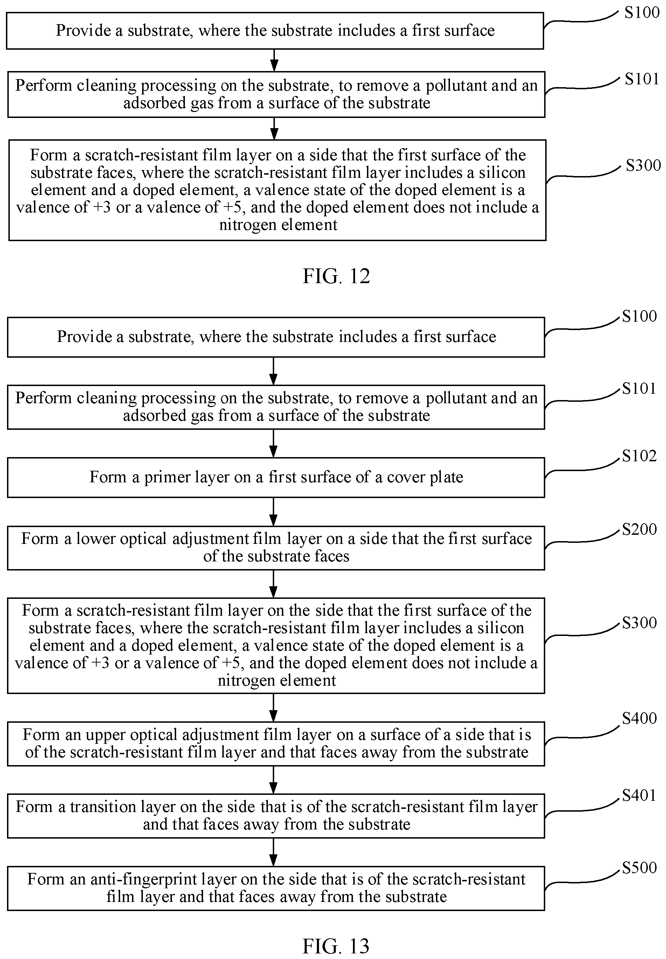

This application further provides a processing method for a cover plate 50. Refer to FIG. 12. FIG. 12 is a processing method for the cover plate 50 according to some embodiments of this application. The cover plate 50 may be the cover plate 50 in any of the foregoing embodiments. The processing method for the cover plate 50 includes:
Step S100: Provide a substrate 51, where the substrate 51 includes a first surface 511.

A material of the substrate 51 may be glass, a ceramic, plastic, or metal.

Step S101: Perform cleaning processing on the substrate 51, to remove a pollutant and an adsorbed gas from a surface of the substrate 51.

It may be understood that, in another embodiment, the processing method for the cover plate 50 may not include step S101. In this case, the substrate 51 provided in step S100 may be the substrate 51 obtained after cleaning processing.

Step S300: Form a scratch-resistant film layer 522 on a side that the first surface 511 of the substrate 51 faces, where the scratch-resistant film layer 522 includes a silicon element and a doped element, the doped element can form a covalent bond with the silicon element, a valence state of the doped element is a valence of +3 or a valence of +5, and the doped element does not include a nitrogen element.

Parameters such as a material, a refractive index, and a physical thickness of the scratch-resistant film layer 522 may be designed with reference to the scratch-resistant film layer 522 in any one of the foregoing embodiments, and details are not described herein again.

In some embodiments, the scratch-resistant film layer 522 may be formed by a sputtering technology. For example, the scratch-resistant film layer 522 may be formed by using a magnetron sputtering technology. Specifically, forming the scratch-resistant film layer 522 using the sputtering technology includes: providing a target. The target material is a silicon target, the target includes the doped element, the doped element can forming a covalent bond with the silicon element, the valence state of the doped element is a valence of +3 or a valence of +5, and the doped element does not include the nitrogen element.

In this way, the doped element is added to the silicon target, to improve an electrical conductivity of the silicon target, thereby effectively avoiding electric charge accumulation on a surface of the silicon target in a process of sputtering the scratch-resistant film layer 522. This helps to reduce a probability of generating an arc discharge phenomenon in the process of sputtering, and can further avoid generation of a large-particle sputtering substance in the process of sputtering, thereby effectively reducing a probability of forming a "white spot" on a surface of the substrate 51, and improving an appearance yield of the cover plate 50.

Refer to FIG. 13. FIG. 13 is a flowchart of a processing method for the cover plate 50 according to some other embodiments of this application. A difference between the processing method for the cover plate 50 in this embodiment and the processing method for the cover plate 50 in the embodiment shown in FIG. 12 lies in that: in the processing method for the cover plate 50 in this embodiment, before the forming a scratch-resistant film layer 522 on a side that the first surface 511 of the substrate 51 faces, the method further includes:
Step S200: Form a lower optical adjustment film layer 5212 on the side that the first surface 511 of the substrate 51 faces.

In this case, the scratch-resistant film layer 522 may be formed on a surface of a side that is of the lower optical adjustment film layer 5212 and that faces away from the substrate 51.

Further, continue to refer to FIG. 13. After the forming a scratch-resistant film layer 522 on a side that the first surface 511 of the substrate 51 faces, that is, after step S300, the processing method for the cover plate 50 further includes:
Step S400: Form an upper optical adjustment film layer 5211 on a surface of a side that is of the scratch-resistant film layer 522 and that faces away from the substrate 51.

Specifically, the upper optical adjustment film layer 5211 and the lower optical adjustment film layer 5212 may both be formed by using a PVD technology (for example, a magnetron sputtering technology). In this way, the obtained lower optical adjustment film layer 5212 has high hardness, and ha good corrosion resistance, drop resistance, and scratch resistance.

Parameters such as a quantity of layers, a material, a refractive index, a physical thickness, and Vickers hardness of the upper optical adjustment film layer 5211 in this embodiment may be designed with reference to the upper optical adjustment film layer 5211 in any embodiment in this application. Parameters such as a quantity of layers, a material, a refractive index, a physical thickness, and Vickers hardness of the lower optical adjustment film layer 5212 in this embodiment may be designed with reference to the lower optical adjustment film layer 5212 in any embodiment in this application. Details are not described herein again.

On the basis of this, to improve an adhesion force between the lower optical adjustment film layer 5212 and the substrate 51, refer to FIG. 13. Before the forming a lower optical adjustment film layer 5212 on the side that the first surface 511 of the substrate 51 faces, the method further includes:

Step S102: Form a primer layer 523 on the first surface 511 of the cover plate 50.

Specifically, the primer layer 523 may be formed on the first surface 511 of the substrate 51 by using a PVD technology (for example, a magnetron sputtering technology or a vacuum evaporation technology). A specific material of the primer layer 523 may be selected based on the material of the substrate 51. Parameters such as a quantity of layers, a material, and a physical thickness of the primer layer 523 in this embodiment may be designed with reference to the primer layer 523 in any embodiment in this application, and details are not described herein again.

It may be understood that, in some other embodiments, the processing method for the cover plate 50 may not include step S102. Alternatively, in another embodiment, a processing method for the cover plate 50 may include only one of step S200 and step 400.

Continue to refer to FIG. 13. After the forming a scratch-resistant film layer 522 on a side that the first surface 511 of the substrate 51 faces, that is, after step S300, the processing method for the cover plate 50 further includes:
Step S500: Form an anti-fingerprint layer 524 on the side that is of the scratch-resistant film layer 522 and that faces away from the substrate 51.

Specifically, in this embodiment, the anti-fingerprint layer 524 is formed on a surface of a side that is of the upper optical adjustment film layer 5211 and that faces away from the substrate 51. It may be understood that, in another embodiment, the anti-fingerprint layer 524 may alternatively be disposed on a surface of another film layer on the surface of the side that is of the scratch-resistant film layer 522 and that faces away from the substrate 51.

In some embodiments, the anti-fingerprint layer 524 may be formed by using a PVD technology (which may be, for example, a vacuum evaporation technology). The anti-fingerprint layer 524 formed by using the vacuum evaporation technology has high hardness and good scratch resistance.

Parameters such as a material, a physical thickness, and Vickers hardness of the anti-fingerprint layer 524 in this embodiment may be designed with reference to the anti-fingerprint layer 524 in any embodiment in this application, and details are not described herein again.

Refer to FIG. 13. Before the forming an anti-fingerprint layer 524 on the side that is of the scratch-resistant film layer 522 and that faces away from the substrate 51, that is, before step S500, the processing method may further include:
step S401: Form a transition layer 525 on the side that is of the scratch-resistant film layer 522 and that faces away from the substrate 51.

Specifically, the transition layer 525 may be formed by using a PVD technology (for example, a magnetron sputtering technology or a vacuum evaporation technology). In this embodiment, the scratch-resistant film layer 522 may be formed on the surface of the side that is of the upper optical adjustment film layer 5211 and that faces away from the substrate 51. In this way, an adhesion force between the anti-fingerprint layer 524 and the upper optical adjustment film layer 5211 can be improved.

It may be understood that step S500 and step S401 in this embodiment of this application may be applied to the processing method in any embodiment of this application. In addition, the processing method in this embodiment of this application may not include step S500, or may not include step S500 and step S401.

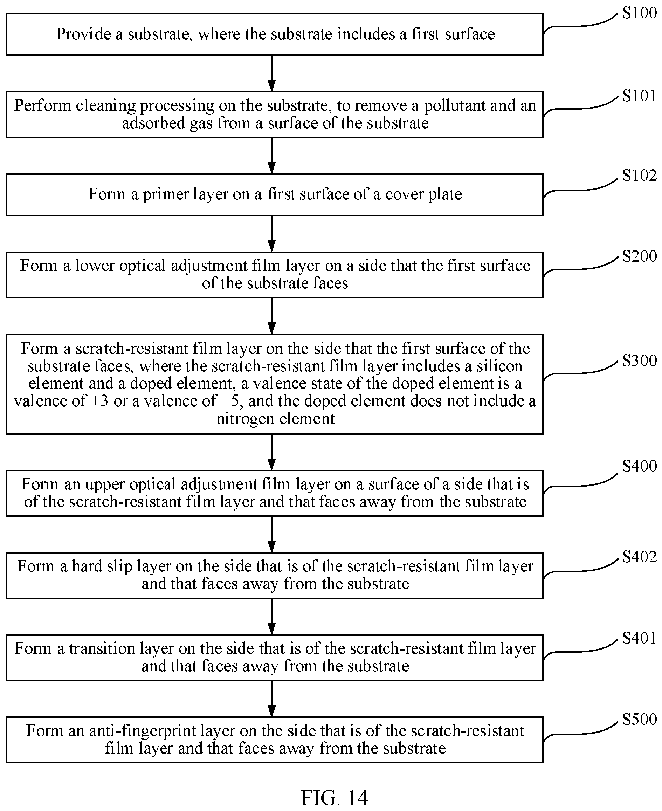

Refer to FIG. 14. FIG. 14 is a flowchart of a processing method for the cover plate 50 according to still other embodiments of this application. A difference between the processing method for the cover plate 50 in this embodiment and the processing method for the cover plate 50 in the embodiment shown in FIG. 13 lies in that, in the processing method for the cover plate 50 in this embodiment, after the forming a scratch-resistant film layer 522 on a side that the first surface 511 of the substrate 51 faces, the method further includes step S402: Form a hard slip layer 526 on the side that is of the scratch-resistant film layer 522 and that faces away from the substrate 51. It may be understood that, step S402 in this embodiment of this application may be applied to the processing method for the cover plate 50 in any embodiment of this application.

The hard slip layer 526 may be formed by using a PVD technology (which may be, for example, a magnetron sputtering technology). The hard slip layer 526 formed by using the PVD technology has high hardness and good scratch resistance.

In some embodiments, the hard slip layer 526 may be formed on the surface of the side that is of the upper optical adjustment film layer 5211 and that faces away from the substrate 51. Parameters such as a material, a dynamic friction coefficient, and a physical thickness of the hard slip layer 526 may be designed with reference to the hard slip layer 526 in any one of the foregoing embodiments, and details are not described herein again.

The following describes two specific embodiments of the cover plate 50 and processing methods thereof in this application.

**Embodiment 1**

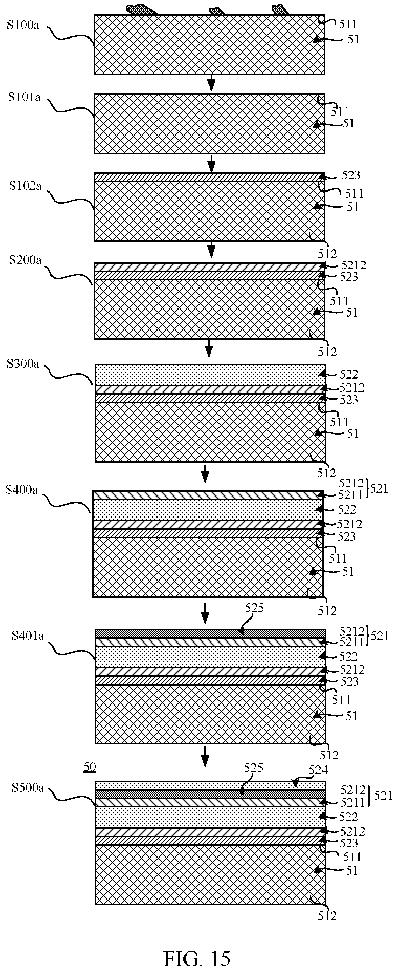

Refer to FIG. 15. FIG. 15 is a flowchart of a processing method for the cover plate 50 in the embodiment shown in FIG. 10. Specifically, the processing method for the cover plate 50 includes:

Step S100a: Provide a substrate 51, where the substrate 51 includes a first surface 511, and a material of the substrate 51 is glass.

Step S101a: Perform cleaning processing on the substrate 51, to remove remove a pollutant and an adsorbed gas from a surface of the substrate 51.

Specifically, step S101a includes: placing the substrate 51 into a PVD furnace to perform argon ion cleaning. A specific cleaning process can be: a base vacuum level in the PVD furnace is approximately $4*10^{-4}$ Pa, an Ar gas is first introduced into the PVD furnace to reach 0.3 Pa to 0.8 Pa (for example, 0.5 Pa), and an Ar+ plasma is generated by capacitive coupling or by using a hot filament plasma source to clean a sample surface for 8 minutes to 15 minutes (for example, 10 minutes) to remove the pollutant and the adsorbed gas on the surface of the substrate 51.

Step S102a: Form a primer layer 523 on the first surface 511 of the substrate 51 by using a magnetron sputtering technology. A material of the primer layer 523 is silicon oxide ($SiO_2$), in other words, the primer layer 523 is a silicon oxide layer.

Specifically, process parameters of step S102a may be: a base vacuum level is approximately $5*10^{-4}$ Pa, a temperature is set to 80 degrees Celsius (°C), a process parameter of a coating machine is set to: power of an inductively coupled plasma generator is 3500 W, a flow rate of argon (Ar) is 200 sccm (a volume flow unit), a flow rate of oxygen ($O_2$) is 120 sccm, and coating time is 2 min, to obtain a silicon oxide primer with a thickness of 10 nm to 50 nm.

Step S200a: Form, by using a magnetron sputtering technology, a lower optical adjustment film layer 5212 on a surface of a side that is of the primer layer 523 and that faces away from the substrate 51.

In this embodiment, the lower optical adjustment film layer 5212 is a single layer, and a material of the lower optical adjustment film layer 5212 includes a mixture silicon oxynitride ($SiO_xN_y$) through atomic-level mixing of silicon nitride ($Si_3N_4$) and silicon oxide ($SiO_2$). According to Table 1, mass fractions of silicon nitride ($Si_3N_4$) and silicon oxide ($SiO_2$) are calculated, and a refractive index of the lower optical adjustment film layer 5212 is controlled to be 1.55 to 1.65.

Specifically, process parameters of step S200a can be: a base vacuum level is approximately $5*10^{-4}$ Pa, a temperature is set to 80 degrees Celsius (°C), and a process parameter of a coating machine is set to: power of an inductively coupled plasma generator is 3500 W, a flow rate of argon (Ar) is 200 sccm (a volume flow unit), a flow rate of oxygen ($O_2$) is 120 sccm, a flow rate of nitrogen ($N_2$) is 50 sccm to 200 sccm, a nitrogen (N2) bias voltage is 0.05 Pa to 0.1 Pa, and coating time is 3 min to 10 min, to obtain a silicon oxynitride ($SiO_xN_y$) layer with a thickness of 100 nm to 300 nm.

Step S300a: Form, by using a magnetron sputtering technology, a scratch-resistant film layer 522 on a surface of a side that is of the lower optical adjustment film layer 5212 and that faces away from the substrate 51.

In this embodiment, a thickness of the scratch-resistant film layer 522 is 500 nm to 3000 nm. A material of the scratch-resistant film layer 522 includes a mixture silicon oxynitride ($SiO_xN_y$) through atomic-level mixing of silicon nitride ($Si_3N_4$) and silicon oxide ($SiO_2$), and the scratch-resistant film layer 522 includes a doped element boron (B). A mass fraction of boron is 0.4%. According to Table 1, the mass fractions of silicon nitride ($Si_3N_4$) and silicon oxide ($SiO_2$) are calculated, and a refractive index of the scratch-resistant film layer 522 is controlled to be 1.65 to 1.80.

Process parameters of step S300a may be: a base vacuum level is approximately $5*10^{-4}$ Pa, a target is a silicon target, a doped element in the target is boron, a mass fraction of boron is 0.4%, sputtering power of the target is 8500 W, a flow rate of argon is 120 sccm, a flow rate of nitrogen is 80 sccm, a flow rate of oxygen is 30 sccm, and power of an inductively coupled plasma generator is 4500 W.

Step S400a: Form, by using a magnetron sputtering technology, an upper optical adjustment film layer 5211 on a surface of a side that is of the scratch-resistant film layer 522 and that faces away from the substrate 51.

In this embodiment, the upper optical adjustment film layer 5211 is a single layer, and a thickness of the upper optical adjustment film layer 5211 is 60 nm to 120 nm. A material of the upper optical adjustment film layer 5211 includes a mixture silicon oxynitride through atomic-level mixing of silicon nitride ($Si_3N_4$) and silicon oxide ($SiO_2$). According to Table 1, the mass fractions silicon nitride ($Si_3N_4$) and silicon oxide ($SiO_2$) are calculated, and a refractive index of the upper optical adjustment film layer 5211 is controlled to be 1.55 to 1.65.

Specifically, process parameters of step S400a may be: a base vacuum level is approximately $5*10^{-4}$ Pa, a temperature is set to 80 degrees Celsius (°C), a process parameter of a coating machine is set to: power of an inductively coupled plasma generator is 3500 W, a flow rate of argon (Ar) is 200 sccm (a volume flow unit), a flow rate of oxygen ($O_2$) is 120 sccm, a flow rate of nitrogen ($N_2$) is 50 sccm to 200 sccm, a nitrogen ($N_2$) bias voltage is 0.05 Pa to 0.1 Pa, coating time is 0.5 min to 2 min, to obtain a silicon oxynitride ($SiO_xN_y$) layer with a thickness of 60 nm to 120 nm.

Step S401a: Form, by using a magnetron sputtering technology, a transition layer 525 on a surface of a side that is of the upper optical adjustment film layer 5211 and that faces away from the substrate 51.

In this embodiment, a material of the transition layer 525 is silicon oxide ($SiO_2$), in other words, the transition layer 525 is silicon oxide ($SiO_2$) film layer.

Process parameters of step S401a may be: sputtering power of a silicon target is 8 KW, a flow rate of Ar is 250 sccm, a flow rate of $O_2$ is 120 sccm, and coating time is 0.5 min to 4 min, to obtain a silicon oxide film layer with a thickness of 8 nm to 13 nm.

To improve an adhesion force between the transition layer 525 and the upper optical adjustment film layer 5211, before the transition layer 525 is formed, anodic plasma processing is performed on a surface of the upper optical adjustment film layer 5211. Specific parameters are: power is 1 KW to 5 KW, a flow rate of Ar is 200 sccm, a flow rate of $O_2$ is 80 sccm, and processing time is 240s.

Step S500a: Form, by using a magnetron sputtering technology, an anti-fingerprint layer 524 on a surface of a side that is of the transition layer 525 and that faces away from the substrate 51, to obtain the cover plate 50.

To obtain the anti-fingerprint layer 524 for preventing pollution, polyperfluoroether siloxane is used as a raw material, and coating parameters are set as: a coating current is 260 A, a flow rate of argon (Ar) is 220 sccm (a volume flow unit), a flow rate of oxygen ($O_2$) is 220 sccm, and coating time is 3 min, to obtain the anti-fingerprint layer 524 with a thickness of 10 nm to 30 nm.

When the cover plate 50 is prepared by using the processing method in this embodiment, an appearance defect rate caused by "target arcing" may be reduced by 80%, and the cover plate 50 has good optical performance, high hardness, and strong scratch resistance.

Specifically, the optical performance of the cover plate 50 is tested by using a spectrophotometer. In this embodiment, a light-transmitting rate of the cover plate 50 in a wave band of 380 nm to 780 nm is 91.7%, reflectivity is 7.8%, and the optical performance is good.

An appearance color of the cover plate 50 is tested by using a colorimeter. According to the International Commission on Illumination, under a condition of normal incidence, in an (L*, a*, b*) colorimetric system, in reflection color values of the cover plate 50, a value a is -0.01, and a value b is 0.23; and in transmission color values, a value a is 0.03, and a value b is 0.65. Under an incident condition of an incident angle of 30°, in the reflection color values of the cover plate 50, the value a is 0.967, and the value b is -0.45. Under an incident condition of an incident angle of 60°, in the reflection color values of the cover plate 50, the value a is 0.449, and the value b is 0.907. The appearance color of the cover plate 50 is good, and an angle discoloration problem and a rainbow edge problem are both effectively improved.

A hardness test is performed on the cover plate 50 by using a Vickers indenter. When a surface indentation depth on a surface of the cover plate 50 is approximately 100 nanometers, measured Vickers hardness is 1200 to 1340. A hardness test is performed on the cover plate 50 by using a Mohs hardness pen. Under a force of 500 g, Mohs hardness is greater than 7. The cover plate 50 has high hardness, and has good wear resistance and scratch resistance. This helps to reduce a scratch on the cover plate 50 and prolong a service life of the cover plate 50.

An eraser friction test is performed on the cover plate 50. After a cyclic test by using a Minorle eraser under a force of 1000 g, a speed of 40 cycles/min, and a test stroke of 4200 cycles, a water drop contact angle is >100°. In addition, a dynamic friction coefficient of the cover plate 50 is less than or equal to 0.05.

It may be understood that when the cover plate 50 in the embodiment shown in FIG. 10 is prepared by using another processing method, the cover plate 50 may also have the foregoing excellent performance.

**Embodiment 2**

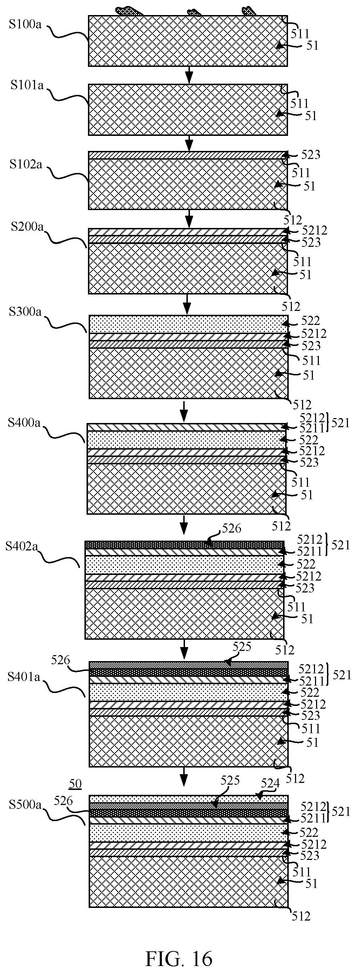

Refer to FIG. 16. FIG. 16 is a flowchart of a processing method for the cover plate 50 shown in FIG. 11. Specifically, a difference between the processing method for the cover plate 50 in this embodiment and the processing method for the cover plate 50 in the embodiment shown in FIG. 16 lies in that, in addition to step S100a to step S500a, before step S500a, the processing method for the cover plate 50 in this embodiment further includes:
Step S402a: Form a hard slip layer 526 on a surface of a side that is of an upper optical adjustment film layer 5211 and that faces away from a substrate 51.

A material of the hard slip layer 526 is diamond-like carbon. A physical thickness of the hard slip layer 526 is less than or equal to 15 nm. Coating parameters are: direct current power is 200 W, a sputtering air pressure is 0.4 Pa, sputtering time is 20 min to 40 min, and a flow rate of Argon is 20 sccm.

Other steps of the processing method for the cover plate 50 in this embodiment may be the same as the processing method for the cover plate 50 in the embodiment shown in FIG. 16, and are not described in detail herein again.

When the cover plate 50 is prepared by using the processing method in this embodiment, an appearance defect rate caused by "target arcing" may also be reduced by 80%, and the cover plate 50 has good optical performance, high hardness, and strong scratch resistance.

Specifically, optical performance of the cover plate 50 is tested by using a spectrophotometer. In this embodiment, a light-transmitting rate of the cover plate 50 in a wave band of 380 nm to 780 nm is 91.1%, reflectivity is 8.4%, and the optical performance is good.

An appearance color of the cover plate 50 is tested by using a colorimeter. According to the International Commission on Illumination, under a condition of normal incidence, in an (L*, a*, b*) colorimetric system, in reflection color values of the cover plate 50, a value a is -0.34, and a value b is 0.1; and in transmission color values, a value a is 0.23, and a value b is 0.73. Under an incident condition of an incident angle of 30°, in the reflection color values of the cover plate 50, the value a is 0.88, and the value b is 0.34. Under an incident condition of an incident angle of 60°, in the reflection color values of the cover plate 50, the value a is 0.35, and the value b is 1.1. The appearance color of the cover plate 50 is good, and an angle discoloration problem and a rainbow edge problem are both effectively improved.

A hardness test is performed on the cover plate 50 by using a Vickers indenter. When a surface indentation depth on a surface of the cover plate 50 is approximately 100 nanometers, measured Vickers hardness is 1100 to 1280. A hardness test is performed on the cover plate 50 by using a Mohs hardness pen. Under a force of 500 g, Mohs hardness is greater than 7. The cover plate 50 has high hardness, and has good wear resistance and scratch resistance. This helps to reduce a scratch on the cover plate 50 and prolong a service life of the cover plate 50.

An eraser friction test is performed on the cover plate 50. After a cyclic test by using a Minorle eraser under a force of 1000 g, a speed of 40 cycles/min, and a test stroke of 4200 cycles, a water drop contact angle is >100°. In addition, a dynamic friction coefficient of the cover plate 50 is less than or equal to 0.05.

It may be understood that when the cover plate 50 in the embodiment shown in FIG. 11 is prepared by using another processing method, the cover plate 50 may also have the foregoing excellent performance.

According to the descriptions of the foregoing embodiments, when the cover plate 50 is applied to the electronic device 100, and is used as the light-transmitting cover plate 11 or the back cover 21 of the electronic device 100, an appearance yield of the electronic device 100 can be improved, the scratch resistance of the cover plate 50 can be improved, and a scratch on the light-transmitting cover plate 11 or the back cover 21 can be effectively reduced. In addition, the optical performance of the cover plate 50 can be optimized, the appearance color of the cover plate 50 can be adjusted, the angle discoloration problem and the rainbow edge problem of the cover plate 50 can be improved, and an effect of the electronic device 100 can be improved.

In the descriptions of this specification, the specific features, structures, materials, or characteristics may be combined in a proper manner in any one or more of embodiments or examples.

In conclusion, it should be noted that, the foregoing embodiments are only used to describe the technical solutions of this application, but not intended to limit this application. Although this application has been described in detail with reference to the foregoing embodiments, it should be understood by a person skilled in the art that the technical solutions described in the foregoing embodiments can still be modified, or some or all of technical features can be equivalently replaced. However, these modifications or replacements do not cause the essence of corresponding technical solutions to depart from the spirit and scope of the technical solutions in embodiments of this application.


**Claims**

1.  A cover plate, comprising:

    a substrate and a scratch-resistant film layer that are disposed in a stacked manner, wherein
    the scratch-resistant film layer comprises a silicon element and a doped element, a valence state of the doped element is a valence of +3 or a valence of +5, and the doped element does not comprise a nitrogen element.

2.  The cover plate according to claim 1, wherein the doped element comprises at least one of a boron element, a phosphorus element, and an aluminum element.

3.  The cover plate according to claim 1 or 2, wherein a mass fraction of the doped element in the scratch-resistant film layer is greater than or equal to 0.2%.

4.  The cover plate according to any one of claims 1 to 3, wherein the mass fraction of the doped element in the scratch-resistant film layer is less than or equal to 3%.

5.  The cover plate according to any one of claims 1 to 4, wherein Vickers hardness of the scratch-resistant film layer is greater than or equal to 1100 HV.

6.  The cover plate according to any one of claims 1 to 5, wherein the scratch-resistant film layer comprises a first material and a second material, a refractive index of the first material is greater than or equal to a refractive index of the substrate, and a refractive index of the second material is less than or equal to the refractive index of the substrate.

7.  The cover plate according to claim 6, wherein the substrate is a glass substrate, and an refractive index of the scratch-resistant film layer is greater than or equal to 1.46 and less than or equal to 1.85.

8.  The cover plate according to claim 6 or 7, wherein the first material comprises at least one of silicon nitride, aluminum nitride, niobium oxide, titanium oxide, and tantalum oxide; and/or

the second material comprises at least one of silicon oxide, magnesium fluoride, and calcium fluoride.

9. The cover plate according to any one of claims 6 to 8, wherein the first material is silicon nitride, the second material is silicon oxide, and a mass fraction of the first material is greater than or equal to 10% and or equal to 80%; or the first material is aluminum oxide, the second material is silicon oxide, and a mass fraction of the first material is greater than or equal to 10% and less than 100%.

10. The cover plate according to any one of claims 1 to 9, wherein a thickness of the scratch-resistant film layer is greater than or equal to 500 nm and less than or equal to 3000 nm.

11. The cover plate according to any one of claims 1 to 10, comprising an upper optical adjustment film layer, wherein the upper optical adjustment film layer is disposed on a side that is of the scratch-resistant film layer and that faces away from the substrate, the upper optical adjustment film layer is a single layer, and a refractive index of the upper optical adjustment film layer is less than the refractive index of the scratch-resistant film layer.

12. The cover plate according to claim 11, wherein the upper optical adjustment film layer comprises at least one high-refractive-index material and at least one low-refractive-index material, and a refractive index of the high-refractive-index material is greater than a refractive index of the low-refractive-index material.

13. The cover plate according to any one of claims 1 to 12, comprising the upper optical adjustment film layer, wherein the upper optical adjustment film layer is disposed on the side that is of the scratch-resistant film layer and that faces away from the substrate, the upper optical adjustment film layer comprises at least one first high-refractive-index film layer and at least one first low-refractive-index film layer that are sequentially stacked and alternately disposed, and a refractive index of the first high-refractive-index film layer is greater than a refractive index of the first low-refractive-index film layer.

14. The cover plate according to any one of claims 11 to 13, a physical thickness of the upper optical adjustment film layer is less than or equal to 300 nm.

15. The cover plate according to any one of claims 11 to 14, wherein a ratio of a physical thickness of the scratch-resistant film layer to the physical thickness of the upper optical adjustment film layer is greater than or equal to 10.

16. The cover plate according to any one of claims 1 to 15, comprising a lower optical adjustment film layer, wherein the lower optical adjustment film layer is disposed on a side that is of the scratch-resistant film layer and that faces the substrate.

17. The cover plate according to any one of claims 1 to 16, comprising a hard slip layer, wherein the hard slip layer is disposed on the side that is of the scratch-resistant film layer and that faces away from the substrate.

18. The cover plate according to claim 17, wherein the hard slip layer comprises one or more carbon materials containing $SP_2$ bonds.

19. The cover plate according to claim 17 or 18, wherein a dynamic friction coefficient of the hard slip layer is less than or equal to 0.05.

20. The cover plate according to any one of claims 17 to 19, a physical thickness of the hard slip layer is less than or equal to 50 nm.

21. The cover plate according to any one of claims 1 to 20, further comprising an anti-fingerprint layer, wherein the anti-fingerprint layer is disposed on the side that is of the scratch-resistant film layer and that faces away from the substrate.

22. The cover plate according to claim 21, wherein a material of the anti-fingerprint layer comprises at least one of polytetrafluoroethylene and cloflucarban.

23. The cover plate according to any one of claims 1 to 22, comprising:

a primer layer, wherein the primer layer is disposed in a stacked manner on a surface that is of the substrate and that faces the scratch-resistant film layer; and

a material of the primer layer comprises at least one of aluminum, chromium, titanium, silicon, and silicon oxide.

24. The cover plate according to any one of claims 1 to 23, wherein according to the International Commission on Illumination, under an incident condition that an incident angle is equal to 60°, a value a and a value b of a reflection color of the cover plate in the Lab color space satisfy: the value a is greater than or equal to -2 and less than or equal to 2, and the value b is greater than or equal to -2 and less than or equal to 2.

25. The cover plate according to any one of claims 1 to 24, Mohs hardness of the cover plate under a force of 500 g is greater than 7.

26. The cover plate according to claim 1 to 25, wherein the substrate is a 2.5D substrate or a 3D substrate.

27. An electronic device, comprising:

a frame;
a screen, wherein the screen comprises a light-transmitting cover plate and a display that are disposed in a stacked manner, and the light-transmitting cover plate is fixedly connected to the frame, and
a back cover, wherein the back cover is disposed on a side that is of the frame and that faces away from the light-transmitting cover plate; and
at least one of the back cover and the light-transmitting cover plate is the cover plate according to any one of claims 1 to 26.

FIG. 1

FIG. 2

FIG. 3

FIG. 4

FIG. 5

FIG. 6

FIG. 7

FIG. 8

FIG. 9

50

525    524

t5
t6
t2    5212
      5211    521
t1    522
t3    5212
t4    523

Z    511
     51

512

FIG. 10

50

526    525    524

t5
t6
t7
t2    5212
      5211    521
t1    522
t3    5212
t4    523

Z    511
     51

512

FIG. 11

| Provide a substrate, where the substrate includes a first surface | S100 |
|---|---|

↓

| Perform cleaning processing on the substrate, to remove a pollutant and an adsorbed gas from a surface of the substrate | S101 |
|---|---|

↓

| Form a scratch-resistant film layer on a side that the first surface of the substrate faces, where the scratch-resistant film layer includes a silicon element and a doped element, a valence state of the doped element is a valence of +3 or a valence of +5, and the doped element does not include a nitrogen element | S300 |
|---|---|

## FIG. 12

| Provide a substrate, where the substrate includes a first surface | S100 |
|---|---|

↓

| Perform cleaning processing on the substrate, to remove a pollutant and an adsorbed gas from a surface of the substrate | S101 |
|---|---|

↓

| Form a primer layer on a first surface of a cover plate | S102 |
|---|---|

↓

| Form a lower optical adjustment film layer on a side that the first surface of the substrate faces | S200 |
|---|---|

↓

| Form a scratch-resistant film layer on the side that the first surface of the substrate faces, where the scratch-resistant film layer includes a silicon element and a doped element, a valence state of the doped element is a valence of +3 or a valence of +5, and the doped element does not include a nitrogen element | S300 |
|---|---|

↓

| Form an upper optical adjustment film layer on a surface of a side that is of the scratch-resistant film layer and that faces away from the substrate | S400 |
|---|---|

↓

| Form a transition layer on the side that is of the scratch-resistant film layer and that faces away from the substrate | S401 |
|---|---|

↓

| Form an anti-fingerprint layer on the side that is of the scratch-resistant film layer and that faces away from the substrate | S500 |
|---|---|

## FIG. 13

Provide a substrate, where the substrate includes a first surface — S100

Perform cleaning processing on the substrate, to remove a pollutant and an adsorbed gas from a surface of the substrate — S101

Form a primer layer on a first surface of a cover plate — S102

Form a lower optical adjustment film layer on a side that the first surface of the substrate faces — S200

Form a scratch-resistant film layer on the side that the first surface of the substrate faces, where the scratch-resistant film layer includes a silicon element and a doped element, a valence state of the doped element is a valence of +3 or a valence of +5, and the doped element does not include a nitrogen element — S300

Form an upper optical adjustment film layer on a surface of a side that is of the scratch-resistant film layer and that faces away from the substrate — S400

Form a hard slip layer on the side that is of the scratch-resistant film layer and that faces away from the substrate — S402

Form a transition layer on the side that is of the scratch-resistant film layer and that faces away from the substrate — S401

Form an anti-fingerprint layer on the side that is of the scratch-resistant film layer and that faces away from the substrate — S500

FIG. 14

FIG. 15

FIG. 16

## INTERNATIONAL SEARCH REPORT

| International application No. |
| --- |
| **PCT/CN2024/106527** |

| A. | CLASSIFICATION OF SUBJECT MATTER |
| --- | --- |

C03C17/22(2006.01)i; C03C17/34(2006.01)i; G02B1/14(2015.01)i; G02B1/11(2015.01)i; H05K5/03(2006.01)i

According to International Patent Classification (IPC) or to both national classification and IPC

| B. | FIELDS SEARCHED |
| --- | --- |

Minimum documentation searched (classification system followed by classification symbols)

IPC:C03C; G02B; H05K

Documentation searched other than minimum documentation to the extent that such documents are included in the fields searched

Electronic data base consulted during the international search (name of data base and, where practicable, search terms used)

CNTXT, ENTXT, WPABS, CNKI; CNABS; ISI; VEN: 盖板, 壳体, 叠层, 基板, 耐划伤, 耐磨, 膜, 层, 掺杂, 三价, 五价, 硼, 磷, 铝, 光学, 减反射, B, P, Al, cover, shell, laminated, substrate, anti-friction, abrasion resist, coating, layer, doped, pentavalent, trivalent, boron, phosphorus, aluminum, optical, antireflection

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 107076874 A (CORNING INC.) 18 August 2017 (2017-08-18) description, paragraphs 0048, 0065-0071, 0106, and 0162-0188, embodiments 1-3, and tables 5-8 | 1-27 |
| X | CN 105874356 A (CORNING INC.) 17 August 2016 (2016-08-17) description, paragraphs 0157-0175 | 1-27 |
| X | CN 107140827 A (CORNING INC.) 08 September 2017 (2017-09-08) description, paragraphs 0158-0176 | 1-27 |
| X | CN 113562985 A (SCHOTT AG) 29 October 2021 (2021-10-29) claims 1-4, 12, and 14 | 1-5, 27 |
| Y | CN 116282955 A (ANHUI JINGZHUO LIGHT DISPLAY TECHNOLOGY CO., LTD.) 23 June 2023 (2023-06-23) claims 1-10 | 1-27 |
| Y | CN 105637114 A (MITSUBISHI MATERIALS CORP.) 01 June 2016 (2016-06-01) claims 1-5 | 1-27 |

| ✓ Further documents are listed in the continuation of Box C. | ✓ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **30 October 2024** | **05 November 2024** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
|---|
| **PCT/CN2024/106527** |

**C. DOCUMENTS CONSIDERED TO BE RELEVANT**

| Category* | Citation of document, with indication, where appropriate, of the relevant passages | Relevant to claim No. |
|---|---|---|
| Y | CN 106133186 A (TOSOH SMD INC.) 16 November 2016 (2016-11-16) <br> claims 1-10 | 1-27 |
| A | CN 101809512 A (CITIZEN HOLDINGS CO., LTD.) 18 August 2010 (2010-08-18) <br> entire document | 1-27 |
| A | CN 114025545 A (GUANGDONG OPPO MOBILE COMMUNICATIONS CO., LTD.) 08 February 2022 (2022-02-08) <br> entire document | 1-27 |
| A | CN 114207481 A (CORNING INC.) 18 March 2022 (2022-03-18) <br> entire document | 1-27 |
| A | CN 220105327 U (LENS TECHNOLOGY CO., LTD.) 28 November 2023 (2023-11-28) <br> entire document | 1-27 |
| A | US 2018029929 A1 (CORNING INC.) 01 February 2018 (2018-02-01) <br> entire document | 1-27 |
| A | US 2022144695 A1 (EUROKERA S.N.C.) 12 May 2022 (2022-05-12) <br> entire document | 1-27 |
| A | US 6344288 B1 (ASAHI GLASS CO., LTD.) 05 February 2002 (2002-02-05) <br> entire document | 1-27 |

Form PCT/ISA/210 (second sheet) (July 2022)

## INTERNATIONAL SEARCH REPORT
### Information on patent family members

| International application No. |
|---|
| **PCT/CN2024/106527** |

| Patent document cited in search report | | | Publication date (day/month/year) | Patent family member(s) | | | Publication date (day/month/year) |
|---|---|---|---|---|---|---|---|
| CN | 107076874 | A | 18 August 2017 | KR | 20200138831 | A | 10 December 2020 |
| | | | | KR | 102310146 | B1 | 12 October 2021 |
| | | | | KR | 20190018054 | A | 20 February 2019 |
| | | | | KR | 102047915 | B1 | 22 November 2019 |
| | | | | EP | 3441374 | A1 | 13 February 2019 |
| | | | | JP | 2017519232 | A | 13 July 2017 |
| | | | | JP | 6761348 | B2 | 23 September 2020 |
| | | | | JP | 2023030036 | A | 07 March 2023 |
| | | | | EP | 3114095 | A1 | 11 January 2017 |
| | | | | EP | 3114095 | B1 | 28 November 2018 |
| | | | | KR | 20170009888 | A | 25 January 2017 |
| | | | | KR | 101950564 | B1 | 20 February 2019 |
| | | | | US | 2015323705 | A1 | 12 November 2015 |
| | | | | US | 9335444 | B2 | 10 May 2016 |
| | | | | WO | 2016018490 | A1 | 04 February 2016 |
| | | | | US | 2016223717 | A1 | 04 August 2016 |
| | | | | US | 9726786 | B2 | 08 August 2017 |
| | | | | JP | 2021006910 | A | 21 January 2021 |
| | | | | TW | 201602623 | A | 16 January 2016 |
| | | | | TWI | 601970 | B | 11 October 2017 |
| | | | | US | 2017336538 | A1 | 23 November 2017 |
| | | | | US | 10436945 | B2 | 08 October 2019 |
| | | | | KR | 20190130688 | A | 22 November 2019 |
| | | | | KR | 102188706 | B1 | 09 December 2020 |
| CN | 105874356 | A | 17 August 2016 | TW | 201516448 | A | 01 May 2015 |
| | | | | TWI | 603110 | B | 21 October 2017 |
| | | | | WO | 2015038835 | A1 | 19 March 2015 |
| | | | | JP | 2016532910 | A | 20 October 2016 |
| | | | | JP | 6771382 | B2 | 21 October 2020 |
| | | | | TW | 201802495 | A | 16 January 2018 |
| | | | | TWI | 638182 | B | 11 October 2018 |
| | | | | EP | 3044615 | A1 | 20 July 2016 |
| | | | | TW | 201920991 | A | 01 June 2019 |
| | | | | TWI | 686620 | B | 01 March 2020 |
| | | | | KR | 20160060075 | A | 27 May 2016 |
| | | | | KR | 102242510 | B1 | 21 April 2021 |
| CN | 107140827 | A | 08 September 2017 | None | | | |
| CN | 113562985 | A | 29 October 2021 | KR | 20210133877 | A | 08 November 2021 |
| | | | | DE | 102021110208 | A1 | 28 October 2021 |
| CN | 116282955 | A | 23 June 2023 | None | | | |
| CN | 105637114 | A | 01 June 2016 | TW | 201606107 | A | 16 February 2016 |
| | | | | TWI | 550117 | B | 21 September 2016 |
| | | | | US | 2016260591 | A1 | 08 September 2016 |
| | | | | EP | 3050999 | A1 | 03 August 2016 |
| | | | | EP | 3050999 | A4 | 31 May 2017 |
| | | | | JP | 5812217 | B1 | 11 November 2015 |
| | | | | JP | 2015212413 | A | 26 November 2015 |
| | | | | WO | 2015159947 | A1 | 22 October 2015 |
| CN | 106133186 | A | 16 November 2016 | KR | 20160142306 | A | 12 December 2016 |

Form PCT/ISA/210 (patent family annex) (July 2022)

**INTERNATIONAL SEARCH REPORT**
Information on patent family members

| International application No. |
| --- |
| **PCT/CN2024/106527** |

| Patent document cited in search report | | | Publication date (day/month/year) | Patent family member(s) | | | Publication date (day/month/year) |
| --- | --- | --- | --- | --- | --- | --- | --- |
| | | | | US | 2017022603 | A1 | 26 January 2017 |
| | | | | JP | 2017512911 | A | 25 May 2017 |
| | | | | TW | 201542847 | A | 16 November 2015 |
| | | | | WO | 2015156972 | A1 | 15 October 2015 |
| CN | 101809512 | A | 18 August 2010 | WO | 2009041528 | A1 | 02 April 2009 |
| | | | | JPWO | 2009041528 | A1 | 27 January 2011 |
| | | | | EP | 2196870 | A1 | 16 June 2010 |
| | | | | EP | 2196870 | A4 | 14 May 2014 |
| | | | | US | 2010196685 | A1 | 05 August 2010 |
| | | | | US | 8568890 | B2 | 29 October 2013 |
| CN | 114025545 | A | 08 February 2022 | | None | | |
| CN | 114207481 | A | 18 March 2022 | US | 2024045106 | A1 | 08 February 2024 |
| | | | | WO | 2021021586 | A1 | 04 February 2021 |
| | | | | US | 2021033751 | A1 | 04 February 2021 |
| | | | | US | 11815657 | B2 | 14 November 2023 |
| | | | | TW | 202110766 | A | 16 March 2021 |
| CN | 220105327 | U | 28 November 2023 | | None | | |
| US | 2018029929 | A1 | 01 February 2018 | KR | 20170122778 | A | 06 November 2017 |
| | | | | KR | 102593891 | B1 | 26 October 2023 |
| | | | | EP | 3262445 | A1 | 03 January 2018 |
| | | | | WO | 2016138195 | A1 | 01 September 2016 |
| | | | | TW | 201643470 | A | 16 December 2016 |
| | | | | US | 10730790 | B2 | 04 August 2020 |
| | | | | JP | 2018509652 | A | 05 April 2018 |
| US | 2022144695 | A1 | 12 May 2022 | DE | 202020005578 | U1 | 28 September 2021 |
| | | | | JP | 2022525975 | A | 20 May 2022 |
| | | | | EP | 3941884 | A1 | 26 January 2022 |
| | | | | EP | 3941884 | B1 | 13 December 2023 |
| | | | | ES | 2973359 | T3 | 19 June 2024 |
| | | | | WO | 2020193347 | A1 | 01 October 2020 |
| | | | | FR | 3093950 | A1 | 25 September 2020 |
| | | | | FR | 3093950 | B1 | 18 June 2021 |
| | | | | KR | 20210138722 | A | 19 November 2021 |
| US | 6344288 | B1 | 05 February 2002 | KR | 20010041308 | A | 15 May 2001 |
| | | | | KR | 100563419 | B1 | 22 March 2006 |
| | | | | WO | 9944080 | A1 | 02 September 1999 |
| | | | | JP | 4147743 | B2 | 10 September 2008 |
| | | | | TW | 412640 | B | 21 November 2000 |
| | | | | DE | 69931045 | D1 | 01 June 2006 |
| | | | | DE | 69931045 | T2 | 30 November 2006 |
| | | | | EP | 1067407 | A1 | 10 January 2001 |
| | | | | EP | 1067407 | A4 | 12 September 2001 |
| | | | | EP | 1067407 | B1 | 26 April 2006 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311819284